# EUROPEAN PATENT APPLICATION

(11) **EP 4 797 533 A1**
(43) Date of publication of application: **26.08.2026**
(21) Application number: 24887640.1
(22) Date of filing: 18.09.2024
(51) Int. Cl.: H03F 3/21

(54) **POWER AMPLIFICATION CIRCUIT, RADIO FREQUENCY GENERATION DEVICE, AND COMMUNICATION SYSTEM**

(30) Priority: 09.11.2023 CN 202311494131
(71) Applicant: HUAWEI TECHNOLOGIES CO., LTD., Shenzhen 518129 (CN)
(72) Inventor: SUN, Jie, Shenzhen, Guangdong 518129 (CN); SHI, Wen, Shenzhen, Guangdong 518129 (CN); CHEN, Jinhu, Shenzhen, Guangdong 518129 (CN); ZENG, Zhixiong, Shenzhen, Guangdong 518129 (CN); CHEN, Wen, Shenzhen, Guangdong 518129 (CN); LI, Song, Shenzhen, Guangdong 518129 (CN)
(74) Representative: Körber, Martin Hans
(86) International application number: PCT/CN2024/119441
(87) International publication number: WO 2025/098022

(57) **Abstract**

Embodiments provide a power amplification circuit, a radio frequency generation device, and a communication system, which are used in the field of wireless communication technologies. The power amplification circuit includes a first primary amplification circuit, a second primary amplification circuit, a first secondary amplification circuit, a second secondary amplification circuit, a first coupler, a second coupler, a first combiner, and a second combiner. An inter-frequency power splitting characteristic is implemented after a signal passes through the first coupler and the second coupler. A bandwidth of the first primary amplification circuit and a bandwidth of the second primary amplification circuit are less than a bandwidth of the first secondary amplification circuit and a bandwidth of the second secondary amplification circuit. By narrowing the bandwidths of the primary amplification circuits, design complexity is reduced. Through a design of the combiners, impedance of the two primary amplification circuits is maintained constant, enabling relatively independent designs of the primary amplification circuits and allowing for easy replacement with another efficient architecture to implement a larger back-off amount. In the embodiments, it may be easier to design a power amplifier with a large bandwidth, a large back-off amount, and high efficiency.

## Description

This application claims priority to Chinese Patent Application No. 202311494131.5, filed with the China National Intellectual Property Administration on November 9, 2023 and entitled "POWER AMPLIFICATION CIRCUIT, RADIO FREQUENCY GENERATION DEVICE, AND COMMUNICATION SYSTEM", which is incorporated herein by reference in its entirety.

### TECHNICAL FIELD

This application relates to the field of wireless communication technologies, and in particular, to a power amplification circuit, a radio frequency generation device, and a communication system.

### BACKGROUND

During application of wireless communication technologies, data information is carried on a radio frequency signal via modulation, and the radio frequency signal is transmitted to implement wireless communication between a transmit side and a receive side. To ensure communication quality of wireless communication, power amplification usually needs to be performed on the radio frequency signal before the radio frequency signal is transmitted. However, as wireless communication technologies evolve, modulation for the radio frequency signal becomes increasingly complex, leading to a higher signal peak-to-average power ratio of an output radio frequency signal. As such, to improve operating efficiency of outputting the radio frequency signal, a power amplifier needs to have a specific power back-off amount.

As communication systems develop toward higher rates and lower latency, the bandwidth of communication signals continues to increase. Because frequency bands of communication signals are fragmented, power amplifiers usually need to be designed for multi-band compatibility and concurrency. For a broadband multi-frequency power amplifier, VBW is a key factor affecting wideband concurrency, and controlling the VBW of the broadband power amplifier is highly challenging. In addition, in a power amplifier design, improving back-off efficiency and extending an operating bandwidth are conflicting requirements, and both involve design difficulties. Therefore, designing a power amplifier that simultaneously provides a large back-off amount, high efficiency, and a high-power broadband is a challenge.

### SUMMARY

Embodiments of this application provide a power amplification circuit, a radio frequency generation device, and a communication system, to implement a design of a power amplifier with a large back-off amount, high efficiency, and a high-power broadband.

To achieve the foregoing objectives, the following technical solutions are used in embodiments of this application.

According to a first aspect, a power amplification circuit is provided, including a first primary amplification circuit, a second primary amplification circuit, a first secondary amplification circuit, a second secondary amplification circuit, a first coupler, a second coupler, a first combiner, and a second combiner. In the first coupler and the second coupler, an isolation path is formed between a first end and a second end, a through path is formed between the first end and a fourth end, and a phase difference of 90° exists between a radio frequency signal output by a third end and a radio frequency signal output by the fourth end. A bandwidth of the first primary amplification circuit and a bandwidth of the second primary amplification circuit are less than a bandwidth of the first secondary amplification circuit and a bandwidth of the second secondary amplification circuit. A third end of the first coupler is coupled to a second end of the second coupler by using the first secondary amplification circuit, and a fourth end of the first coupler is coupled to a first end of the second coupler by using the second secondary amplification circuit. An output end of the first primary amplification circuit is coupled to a first end of the first combiner, a third end of the second coupler is coupled to a second end of the first combiner, an output end of the second primary amplification circuit is coupled to a first end of the second combiner, and a fourth end of the second coupler is coupled to a second end of the second combiner. A first end of the first coupler and an input end of the first primary amplification circuit each are configured to receive a first radio frequency signal, a second end of the first coupler and an input end of the second primary amplification circuit each are configured to receive a second radio frequency signal, a frequency band of the first radio frequency signal is different from a frequency band of the second radio frequency signal, and a third end of the first combiner and a third end of the second combiner each are configured to output a combined radio frequency signal.

In some examples, the coupler may be a crossed broadside coupler, a branch-line coupler, a parallel broadside coupler, or the like. The branch-line coupler is used as an example. A third end and a fourth end of the coupler respectively output a radio frequency signal whose phase is shifted by 180° and a radio frequency signal whose phase is shifted by 90°. The crossed broadside coupler is used as an example. A third end and a fourth end of the coupler respectively output a radio frequency signal whose phase is shifted by 90° and a radio frequency signal whose phase is not shifted. All these couplers can meet that a phase difference of 90° exists between the third end and the fourth end. During actual application, whether a connection relationship of the coupler is a connection relationship recorded in this solution is determined based on connection of end locations of coupling ends, through ends, and the like, instead of being determined based on a relative connection direction between ends on a same side of the coupler.

In this embodiment of this application: First, the bandwidth of the first primary amplification circuit and the bandwidth of the second primary amplification circuit are set to be less than the bandwidth of the first secondary amplification circuit and the bandwidth of the second secondary amplification circuit. By designing bandwidths of the two primary circuits to be narrowband, the two primary circuits can function as two narrow-bandwidth power amplification units. Reducing a hardware design bandwidth facilitates narrowband impedance convergence, which helps improve ultimate performance, so that problems of deterioration of power, efficiency, and linear performance in a concurrency scenario can be resolved. Second, the first coupler and the second coupler control signal phases to generate in-phase combination and reverse cancellation, so as to implement an inter-frequency power splitting characteristic. In comparison with a solution in which an inter-frequency power splitter is used to split radio frequency signals of different frequency bands, the inter-frequency power splitting structure may have better out-of-band isolation and a smaller insertion loss, improving design solution efficiency and enhancing link linear performance. Third, radio frequency signals of different frequency bands are split into two radio frequency signals: The first radio frequency signal and the second radio frequency signal, and a dual-output architecture with two outputs of the second coupler may be used to avoid problems of a large insertion loss and poor linearity caused by use of a broadband isolator. In addition, because the broadband isolator also poses design challenges, avoiding the use of the broadband isolator reduces the design complexity. Fourth, a power sharing structure including a primary circuit and a secondary circuit may increase a back-off amount of a power amplifier and improve efficiency, thereby achieving a power amplifier energy-saving characteristic and reducing solution costs. In this embodiment of this application, in the foregoing manner, a design of a power amplifier with a large back-off amount, a large bandwidth, and high operating efficiency can be more easily implemented.

In a possible implementation, the first combiner and the second combiner each are a circulator. In the circulator, a radio frequency signal is transmitted in a flow direction of a first end, a second end, and a third end of the circulator, and is not transmitted in a reverse direction. The third end of the first combiner is configured to output a first combined radio frequency signal; the third end of the second combiner is configured to output a second combined radio frequency signal; the first combined radio frequency signal is a combined signal of the first radio frequency signal; and the second combined radio frequency signal is a combined signal of the second radio frequency signal. In this embodiment of this application, impedance of the circulator is not constant, and may be correspondingly designed based on an actual design requirement. The circulator is used as the first combiner and the second combiner, so that the primary amplification circuit can be relatively independent, which is convenient for design. In addition, it is easier to perform structural extended design on each amplification branch.

In a possible implementation, when the circulator is used as the first combiner and the second combiner, a minimum turn-on operating power point of the first primary amplification circuit is lower than a minimum turn-on operating power point of the first secondary amplification circuit, a minimum turn-on operating power point of the second primary amplification circuit is lower than the minimum turn-on operating power point of the first secondary amplification circuit, and the minimum turn-on operating power point of the first secondary amplification circuit is lower than, equal to, or higher than a minimum turn-on operating power point of the second secondary amplification circuit.

For example, when the minimum turn-on operating power point of the first secondary amplification circuit is equal to the minimum turn-on operating power point of the second secondary amplification circuit, the first primary amplification circuit, the second primary amplification circuit, the first secondary amplification circuit, and the second secondary amplification circuit may form an inter-frequency power splitting architecture through the second coupler. Specifically, when the first secondary amplification circuit and the second secondary amplification circuit are turned on simultaneously, the two secondary amplification circuits form a balanced amplification circuit. In this case, the two secondary amplification circuits transmit the first radio frequency signal and the second radio frequency signal to the first end and the second end of the second coupler simultaneously. In the foregoing manner, when the minimum turn-on operating power point of the first secondary amplification circuit is equal to the minimum turn-on operating power point of the second secondary amplification circuit, power combination is separately performed on the first radio frequency signal and the second radio frequency signal based on the coupler, and the first combined radio frequency signal and the second combined radio frequency signal of different frequency bands are output after inter-frequency power splitting is performed based on the coupler.

For example, when the minimum turn-on operating power point of the first secondary amplification circuit is lower than the minimum turn-on operating power point of the second secondary amplification circuit, the first primary amplification circuit may form a CLMA-Doherty architecture with the first secondary amplification circuit and the second secondary amplification circuit. The second primary amplification circuit may also form a CLMA-Doherty architecture with the first secondary amplification circuit and the second secondary amplification circuit. Specifically, the first primary amplification circuit, the first secondary amplification circuit, and the second secondary amplification circuit may implement power combination based on the circulator, to obtain the first combined radio frequency signal. The second primary amplification circuit, the first secondary amplification circuit, and the second secondary amplification circuit may also implement power combination by using the circulator, to obtain the second combined radio frequency signal. Due to a phase shift effect brought by the first coupler, a phase difference exists between radio frequency signals on the first secondary amplification circuit and the second secondary amplification circuit. In this way, the first radio frequency signals input to the first end and the second end of the second coupler cancel each other at the fourth end of the second coupler, so that the fourth end of the second coupler outputs only the second combined radio frequency signal corresponding to the second radio frequency signal. In addition, the second radio frequency signals input to the first end and the second end of the second coupler cancel each other at the third end of the second coupler, so that the third end of the second coupler outputs only the first combined radio frequency signal corresponding to the first radio frequency signal.

A difference between a case in which the minimum turn-on operating power point of the first secondary amplification circuit is equal to or higher than the minimum turn-on operating power point of the second secondary amplification circuit and a case in which the minimum turn-on operating power point of the first secondary amplification circuit is lower than the minimum turn-on operating power point of the second secondary amplification circuit lies in different turn-on sequences of the two secondary amplification circuits. For related technical principles, refer to related descriptions of the foregoing embodiment in which the minimum turn-on operating power point of the first secondary amplification circuit is lower than the minimum turn-on operating power point of the second secondary amplification circuit. Details are not described herein again.

In a possible implementation, the first combiner and the second combiner are inter-frequency power splitters. The first ends and the third ends of the first combiner and the second combiner are splitting ends of the inter-frequency power splitters. The second ends of the first combiner and the second combiner are combining ends of the inter-frequency power splitters. The first end of the first combiner presents band-pass for the first radio frequency signal and presents band-stop for the second radio frequency signal, the third end of the first combiner presents band-pass for the second radio frequency signal and presents band-stop for the first radio frequency signal, the second end of the first combiner presents band-pass for the first radio frequency signal and the second radio frequency signal, and the third end of the first combiner is configured to output a second combined radio frequency signal. The first end of the second combiner presents band-pass for the second radio frequency signal and presents band-stop for the first radio frequency signal, the third end of the first combiner presents band-pass for the first radio frequency signal and presents band-stop for the second radio frequency signal, the second end of the second combiner presents band-pass for the first radio frequency signal and the second radio frequency signal, and the third end of the second combiner is configured to output a first combined radio frequency signal. The first combined radio frequency signal is a combined signal of the first radio frequency signal, and the second combined radio frequency signal is a combined signal of the second radio frequency signal. In this embodiment of this application, the inter-frequency power splitter is used as the first combiner and the second combiner, so that flow directions of the first radio frequency signal and the second radio frequency signal can be changed, thereby reducing a transmission insertion loss, and making it easier to design and extend the power amplification circuit.

For example, when the inter-frequency power splitter is used as the first combiner and the second combiner, a minimum turn-on operating power point of the first primary amplification circuit is lower than a minimum turn-on operating power point of the first secondary amplification circuit, a minimum turn-on operating power point of the second primary amplification circuit is lower than the minimum turn-on operating power point of the first secondary amplification circuit, and the minimum turn-on operating power point of the first secondary amplification circuit may be lower than, equal to, or higher than a minimum turn-on operating power point of the second secondary amplification circuit. For example, the minimum turn-on operating power point of the first secondary amplification circuit may be equal to the minimum turn-on operating power point of the second secondary amplification circuit, and the first primary amplification circuit may form an SLMBA architecture with the first secondary amplification circuit and the second secondary amplification circuit. The second primary amplification circuit may also form an SLMBA architecture with the first secondary amplification circuit and the second secondary amplification circuit. Frequency splitting processing is performed on two radio frequency signals of different frequency bands through the first coupler and the second coupler, and are respectively output from the third end and the fourth end of the second coupler.

In a possible implementation, at least one of the first primary amplification circuit, the second primary amplification circuit, the first secondary amplification circuit, and the second secondary amplification circuit is a power combining circuit, and the power combining circuit includes a plurality of amplification branch circuits. In this embodiment of this application, the first combiner and the second combiner are used. Therefore, load impedance of the primary amplification circuit is constant and relatively independent, and one or more of the first primary amplification circuit, the second primary amplification circuit being a power combining circuit, the first secondary amplification circuit, and the second secondary amplification circuit may be designed in an extended manner. When a power combining circuit design is used, a power back-off amount of the power amplification circuit may be increased.

For example, the power combining circuit includes at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation amplification circuit.

In a possible implementation, the power amplification circuit further includes a splitting circuit. The splitting circuit is configured to: input the first radio frequency signal and the second radio frequency signal, separately output the first radio frequency signal to the input end of the first primary amplification circuit and the first end of the first coupler, and separately output the second radio frequency signal to the input end of the second primary amplification circuit and the second end of the first coupler. In this embodiment of this application, the first radio frequency signal and the second radio frequency signal may be input by using the splitting circuit, and be split into a plurality of first radio frequency signals and a plurality of second radio frequency signals, for power sharing and power combination.

In a possible implementation, the splitting circuit includes a first power splitter and a second power splitter. A combining end of the first power splitter is configured to receive the first radio frequency signal, and a first splitting end and a second splitting end of the first power splitter are separately configured to output one first radio frequency signal. A combining end of the second power splitter is configured to receive the second radio frequency signal, and a first splitting end and a second splitting end of the second power splitter are separately configured to output one second radio frequency signal. In this embodiment of this application, the first radio frequency signal and the second radio frequency signal may be respectively input through two power splitters, and the first radio frequency signal and the second radio frequency signal are separately split.

In a possible implementation, the splitting circuit includes a first inter-frequency power splitter and a second inter-frequency power splitter. A combining end of the first inter-frequency power splitter is configured to receive the first radio frequency signal and the second radio frequency signal, a first splitting end of the first inter-frequency power splitter outputs one first radio frequency signal, and a second splitting end of the first inter-frequency power splitter is configured to output one second radio frequency signal. A combining end of the second inter-frequency power splitter is configured to receive the first radio frequency signal and the second radio frequency signal. A first splitting end of the second inter-frequency power splitter outputs one first radio frequency signal, and a second splitting end of the second inter-frequency power splitter is configured to output one second radio frequency signal. In this embodiment of this application, both inter-frequency power splitters receive radio frequency signals including the first radio frequency signal and the second radio frequency signal, and each inter-frequency power splitter performs inter-frequency power splitting to output the first radio frequency signal and the second radio frequency signal.

In a possible implementation, the splitting circuit includes a third inter-frequency power splitter, a third power splitter, and a fourth power splitter. A first splitting end and a second splitting end of the third inter-frequency power splitter are respectively coupled to a combining end of the third power splitter and a combining end of the fourth power splitter. A combining end of the third inter-frequency power splitter is configured to receive the first radio frequency signal and the second radio frequency signal. The first splitting end of the third inter-frequency power splitter is configured to output the first radio frequency signal. The second splitting end of the third inter-frequency power splitter is configured to output the second radio frequency signal. A first splitting end and a second splitting end of the third power splitter are separately configured to output one first radio frequency signal. A first splitting end and a second splitting end of the fourth power splitter are separately configured to output one second radio frequency signal. In this embodiment of this application, the inter-frequency power splitter may be used to perform inter-frequency power splitting on radio frequency signals including the first radio frequency signal and the second radio frequency signal, and then the first radio frequency signal and the second radio frequency signal are respectively output to the third power splitter and the fourth power splitter. The third power splitter splits the input first radio frequency signal into a plurality of paths. The fourth power splitter splits the input second radio frequency signal into a plurality of paths.

In a possible implementation, the first radio frequency signal and the second radio frequency signal include a radio frequency signal of one or more sub-bands. In this embodiment of this application, a radio frequency signal with a large relative bandwidth may be split into a plurality of first radio frequency signals and second radio frequency signals with a small relative bandwidth. A smaller relative bandwidth facilitates convergence of an impedance design, and efficiency of each amplification branch can be further improved, thereby improving back-off efficiency and full-load efficiency of the power amplification circuit. In addition, a conventional wideband primary amplification circuit is split into a plurality of radio frequency signals with a small relative bandwidth, so that a difficult VBW design problem in a concurrency scenario can be avoided, and concurrent performance is not deteriorated.

According to a second aspect, an embodiment of this application further provides a radio frequency generation device. The radio frequency generation device includes a radio frequency generation circuit and the power amplification circuit described in the first aspect. The radio frequency generation circuit is configured to output a radio frequency signal to the power amplification circuit. The power amplification circuit is configured to perform power-combining amplification based on the radio frequency signal.

According to a third aspect, an embodiment of this application further provides a communication system. The communication system includes a baseband processing device and the radio frequency generation device described in the second aspect. The baseband processing device is configured to output a baseband signal to the radio frequency generation device. The radio frequency generation device is configured to: obtain a radio frequency signal based on the baseband signal, and perform power-combining amplification on the radio frequency signal.

According to a fourth aspect, an embodiment of this application further provides a chip system. The chip system includes at least one processor and at least one interface circuit. The at least one processor and the at least one interface circuit may be interconnected through a line. The processor is configured to support the chip system in implementing functions or steps in the foregoing embodiments. The at least one interface circuit may be configured to receive a signal from another apparatus (for example, a communication interface, a radio frequency generation circuit, a power amplification circuit, or an antenna), or send a signal to another apparatus (for example, a communication interface, a radio frequency generation circuit, a power amplification circuit, or an antenna). The chip system may include a chip, and may further include another discrete component.

### BRIEF DESCRIPTION OF DRAWINGS

FIG. 1 is a schematic of a structure of a power amplifier;
FIG. 2 is a diagram of a structure of a communication system according to an embodiment of this application;
FIG. 3 is a diagram of a structure of another communication system according to an embodiment of this application;
FIG. 4 is a diagram of a structure of a first power amplification circuit according to an embodiment of this application;
FIG. 5 is a diagram of a structure of a second power amplification circuit according to an embodiment of this application;
FIG. 6 is a diagram of a structure of a third power amplification circuit according to an embodiment of this application;
FIG. 7 is a diagram of a structure of a fourth power amplification circuit according to an embodiment of this application;
FIG. 8 is a diagram of a structure of a fifth power amplification circuit according to an embodiment of this application;
FIG. 9 is a first diagram of a structure of a sixth power amplification circuit according to an embodiment of this application;
FIG. 10 is a diagram of a structure of a coupler;
FIG. 11 is a second diagram of a structure of another sixth power amplification circuit according to an embodiment of this application;
FIG. 12 is a third diagram of a structure of still another sixth power amplification circuit according to an embodiment of this application;
FIG. 13 is a diagram of an input power versus a current of the sixth power amplification circuit shown in FIG. 11 according to an embodiment of this application;
FIG. 14 is a diagram of an input power versus a voltage of the sixth power amplification circuit shown in FIG. 11 according to an embodiment of this application;
FIG. 15 is a diagram of an input power versus impedance of the sixth power amplification circuit shown in FIG. 11 according to an embodiment of this application;
FIG. 16 is a diagram of an input power versus efficiency of the sixth power amplification circuit shown in FIG. 11 according to an embodiment of this application;
FIG. 17 is a fourth diagram of a structure of still another sixth power amplification circuit according to an embodiment of this application;
FIG. 18 is a diagram of an input power versus a current of the sixth power amplification circuit shown in FIG. 17 according to an embodiment of this application;
FIG. 19 is a diagram of an input power versus a voltage of the sixth power amplification circuit shown in FIG. 17 according to an embodiment of this application;
FIG. 20 is a diagram of an input power versus impedance of the sixth power amplification circuit shown in FIG. 17 according to an embodiment of this application;
FIG. 21 is a diagram of an input power versus efficiency of the sixth power amplification circuit shown in FIG. 17 according to an embodiment of this application;
FIG. 22 is a fifth diagram of a structure of still another sixth power amplification circuit according to an embodiment of this application;
FIG. 23 is a diagram of an input power versus a current of the sixth power amplification circuit shown in FIG. 22 according to an embodiment of this application;
FIG. 24 is a diagram of an input power versus a voltage of the sixth power amplification circuit shown in FIG. 22 according to an embodiment of this application;
FIG. 25 is a diagram of an input power versus impedance of the sixth power amplification circuit shown in FIG. 22 according to an embodiment of this application;
FIG. 26 is a diagram of an input power versus efficiency of the sixth power amplification circuit shown in FIG. 22 according to an embodiment of this application;
FIG. 27 is a sixth diagram of a structure of still another sixth power amplification circuit according to an embodiment of this application;
FIG. 28 is a seventh diagram of a structure of still another sixth power amplification circuit according to an embodiment of this application;
FIG. 29 is an eighth diagram of a structure of still another sixth power amplification circuit according to an embodiment of this application; and
FIG. 30 is a ninth diagram of a structure of still another sixth power amplification circuit according to an embodiment of this application.

### DESCRIPTION OF EMBODIMENTS

It should be noted that terms such as "first" and "second" in embodiments of this application are merely used to distinguish between features of a same type, and cannot be understood as an indication of relative importance, a quantity, a sequence, or the like.

The terms such as "example" or "for example" in embodiments of this application represents giving an example, an illustration, or a description. Any embodiment or design scheme described as an "example" or "for example" in this application should not be explained as being more preferred or having more advantages than another embodiment or design scheme. Exactly, use of the terms such as "example" or "for example" is intended to present a related concept in a specific manner.

The terms "coupling" and "connection" in embodiments of this application should be understood in a broad sense. For example, the terms may mean a physical direct connection, or may mean an indirect connection implemented through an electronic component, for example, a connection implemented through a resistor, an inductor, a capacitor, or another electronic component.

First, some basic concepts in embodiments of this application are explained and described.

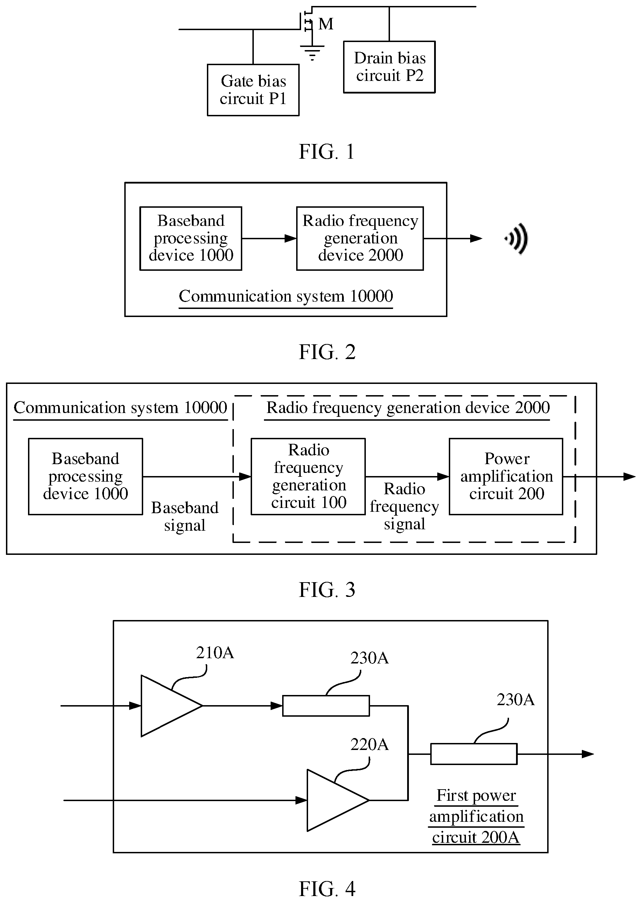

Power amplifier: FIG. 1 shows a basic structure of the power amplifier. In the figure, a gate bias circuit P1 is disposed at a gate of a power amplifier transistor M, and a drain bias circuit P2 is disposed at a drain of the power amplifier transistor M. The gate bias circuit P1 and the drain bias circuit P2 control bias states of electrodes of the power amplifier transistor M, so that the power amplifier transistor M is in a power amplification state. The power amplifier transistor M in the power amplification state may perform power amplification on an input signal. Different gate voltage configurations of power transistors lead to different minimum turn-on power points, which in turn correspond to different power states of the power transistors. Operating states of amplifiers may be classified into class A, class B, class AB, and class C. A class-A power amplifier exhibits the highest linearity and is suitable for power amplification of a small direct current signal. A class-B power amplifier operates in a half-cycle manner. A single-ended class-B power amplifier may produce significant non-linear distortion, and is seldom used for power amplification of a radio frequency signal. Generally, a push-pull structure is formed based on two class-B power amplifiers to produce a positive half cycle and a negative half cycle, and is used for power amplification of an audio signal. A class-AB power amplifier is a combination of the class-A power amplifier and the class-B power amplifier. Efficiency and linearity of the class-AB power amplifier are between efficiency and linearity of the class-A power amplifier and efficiency and linearity of the class-B power amplifier, and the class-AB power amplifier is widely used for power amplification of a radio frequency signal. In embodiments of this application, for a class-C power amplifier, based on different minimum turn-on operating power points of the class-C power amplifier, class-C degrees may be further classified, for example, classified into shallow class C, class C, and deep class C. This type of division is only used for representation in a plurality of class-C power amplifiers in embodiments of this application.

Power back-off of the power amplifier: With development of wireless communication technologies, a modulation technology for a radio frequency signal is gradually complex, leading to a larger signal peak to average power ratio (peak to average power ratio, PAPR) of an output radio frequency signal. A radio frequency signal input to the power amplifier is a modulated signal obtained by modulating data information to a carrier signal. A power back-off amount is related to a peak to average power ratio of the modulated signal.

Operating efficiency of the power amplifier: The operating efficiency of the power amplifier may be reflected by operating efficiency of the drain of the power amplifier transistor M, to be specific, a rate at which a drain direct current provided by a system is converted into a radio frequency signal actually output by the power amplifier. The operating efficiency of the power amplifier decreases with the decrease of an output power.

An embodiment of this application provides a communication system. As shown in FIG. 2, the communication system 10000 includes a baseband processing device 1000 and a radio frequency generation device 2000. The baseband processing device 1000 is coupled to the radio frequency generation device 2000. The baseband processing device 1000 is configured to output a baseband signal to the radio frequency generation device 2000. The radio frequency generation device 2000 is configured to: obtain a radio frequency signal based on the baseband signal, and perform power-combining amplification on the radio frequency signal.

As shown in FIG. 3, the radio frequency generation device 2000 includes a radio frequency generation circuit 100 and a power amplification circuit 200. An output end of the radio frequency generation circuit 100 is coupled to the power amplification circuit 200. The radio frequency generation circuit 100 is configured to output a radio frequency signal to the power amplification circuit 200. The power amplification circuit 200 is configured to perform power-combining amplification based on the radio frequency signal.

For example, the radio frequency generation device 2000 may be a radio remote unit (remote radio unit, RRU) or an active antenna unit (active antenna unit, AAU). The baseband processing device 1000 may be a baseband processing unit (building baseband unit, BBU) or the like.

With the development of wireless communication technologies, an amount of data information that needs to be carried on a radio frequency signal also increases rapidly. Consequently, a bandwidth requirement on the radio frequency signal increases. To ensure efficiency of a radio frequency signal with a high peak to average power ratio after power amplification, a power back-off amount needs to be increased as much as possible. A power amplifier is a most power-consumed component in a transmitting apparatus. In a case of a large amount of power back-off, how to ensure that the power amplifier maintains high efficiency is a major challenge. In addition, in a design of the power amplifier, improving back-off efficiency and extending an operating bandwidth are conflicting key requirements, and both have design difficulties. A design of a power amplifier with a high power, a large bandwidth, a large back-off amount, and high efficiency has always been a challenge in the industry. The main difficulties are as follows: Difficulty 1: From a perspective of designing an efficient power amplifier, improving back-off efficiency is in conflict with extending an operating bandwidth. In an architecture design of most power amplifiers, a bandwidth and efficiency need to be balanced, making it impossible to achieve expected ultimate efficiency. Difficulty 2: From a perspective of designing a high-power power amplifier, a power transistor of the power amplifier has smaller matching impedance and greater parasitic parameter impact, which seriously affects a design of a solution. Difficulty 3: From a perspective of designing a broadband multi-frequency power amplifier, a video bandwidth (video bandwidth, VBW) is an important factor that affects wideband concurrency, and controlling of the VBW of the broadband power amplifier is also very challenging in design. Difficulty 4: An output end of a power amplifier in a base station needs to be connected to an isolator to ensure that performance of the power amplifier is not affected by back-end impedance mismatch. Performance of the output isolator of a high-power wideband power amplifier greatly affects performance such as an output insertion loss and linearity.

In some possible implementations, the power amplification circuit 200 may be a first power amplifier of a Doherty architecture. As shown in FIG. 4, the first power amplification circuit 200A includes a primary amplification branch 210A, a secondary amplification branch 220A, and an impedance inverter line 230A. The primary amplification branch 210A operates in class B or class AB, and the secondary amplification branch 220A operates in class C. When an input radio frequency signal has a low signal power, the primary amplification branch 210A is turned on to operate. When the input radio frequency signal has a high signal power, the secondary amplification branch 220A is turned on to operate. When the secondary amplification branch 220A is turned on, the impedance inverter line 230A performs impedance inversion between impedance at a combination point of the primary amplification branch 210A and the secondary amplification branch 220A and impedance of the primary amplification branch 210A, so as to implement, under load pull, power combination of radio frequency signals output by the two branches. By using the Doherty architecture shown in FIG. 4 and a variant architecture of the Doherty architecture, a good power back-off amount and operating efficiency may be maintained in single-band or dual-band signal amplification. However, to achieve a larger back-off amount or the like in the architecture shown in FIG. 4, additional impedance inverter lines 230A and additional secondary amplification branches 220A are required, which increases component costs and a component area of the first power amplification circuit 200A. In addition, when a quantity of secondary amplification branches 220A reaches a specific value, an amplification gain coefficient of the first power amplification circuit 200A decreases. In addition, the impedance inverter line 230A has a specific frequency response, which causes a bandwidth limitation, and makes a wideband design extremely difficult for the first power amplification circuit 200A.

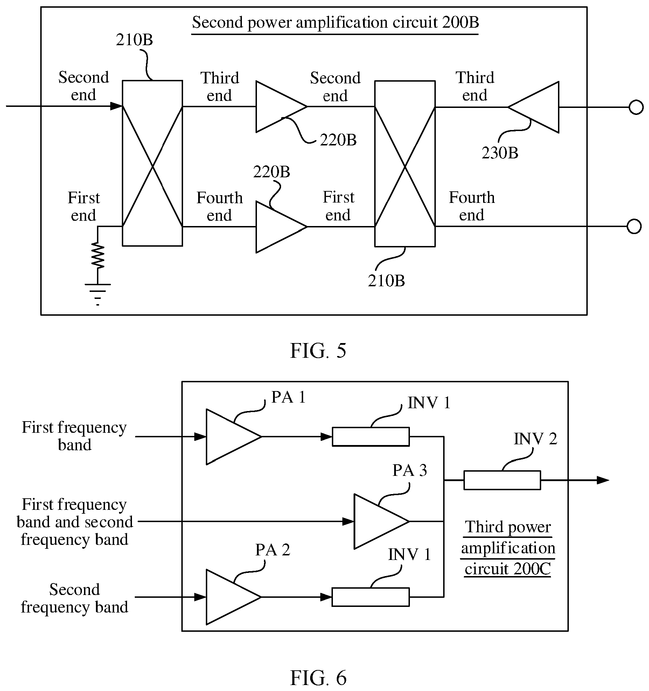

In some possible implementations, the power amplification circuit 200 may be a second power amplifier based on a load modulated balanced amplifier (load modulated balanced amplifier, LMBA) architecture or a sequential load modulated balanced amplifier (sequential load modulated balanced amplifier, SLMBA) architecture. As shown in FIG. 5, the second power amplification circuit 200B may include two balanced couplers 210B, two balanced amplification circuits 220B, and a control amplification circuit 230B. A third end and a fourth end of a front-end balanced coupler 210B are respectively coupled to receive ends of the two balanced amplification circuits 220B, and are coupled to a first end and a second end of a back-end balanced coupler 210B by using output ends of the two balanced amplification circuits 220B. An output end of the control amplification circuit 230B is coupled to a third end of the back-end balanced coupler 210B. A fourth end of the back-end balanced coupler 210B is used as an output end of the second power amplification circuit 200B. In some examples, the two balanced amplification circuits 220B are primary amplifiers operating in class AB, and the control amplification circuit 230B is a secondary amplifier operating in class C. In this case, the second power amplification circuit 200B is an LMBA-based power amplifier. In some examples, the two balanced amplification circuits 220B are secondary amplifiers operating in class C, and the control amplification circuit 230B is a primary amplifier operating in class AB. In this case, the second power amplification circuit 200B is an SLMBA-based power amplifier. In the embodiment shown in FIG. 5, the third end and the fourth end of the front-end balanced coupler 210B output two radio frequency signals with a phase difference of 90°. The two radio frequency signals are power amplified by using the balanced amplification circuit 220B and then output to the back-end balanced coupler 210B. A radio frequency signal output by the control amplification circuit 230B coupled to the back-end balanced coupler 210B may control the back-end balanced coupler 210B to perform amplitude and phase adjustment on the three radio frequency signals, so that an optimal load-pull effect is obtained on each frequency band; and a radio frequency signal obtained through power combination is output from the fourth end of the back-end balanced coupler 210B. However, in the solution design shown in FIG. 5: First, to meet a current base station requirement, a power ratio solution in which an operating power of a secondary amplifier is higher than an operating power of a primary amplifier is usually used, which results in efficiency notch that cannot be ignored. Second, in a wideband scenario, it is difficult to control a VBW, and problems of deterioration of power, efficiency, and linearity performance still exist in a concurrency scenario. Third, a balanced coupler is used as an output power combining unit in the architecture, and in a current high-power power amplifier design, a power capacity of the balanced coupler is a major challenge. Fourth, it is difficult for a broadband isolator connected to an output of a single-output power amplifier solution to achieve good performance.

In some possible implementations, the power amplification circuit 200 may be a third power amplification circuit based on a secondary-sharing dual-band single-output Doherty architecture. As shown in FIG. 6, the third power amplification circuit 200C includes a first single-band primary amplification circuit PA 1, a second single-band primary amplification circuit PA 2, a dual-band shared secondary amplification circuit PA 3, first impedance inverter networks INV 1, and a second impedance transformation network INV 2. The first single-band primary amplification circuit PA 1 operates in class AB, and is configured to perform power amplification on a radio frequency signal of a first frequency band. The second single-band primary amplification circuit PA 2 operates in class AB, and is configured to perform power amplification on a radio frequency signal of a second frequency band. The dual-band shared secondary amplification circuit PA 3 operates in class C, and is configured to perform power amplification on radio frequency signals of the first frequency band and the second frequency band. An output end of the first single-band primary amplification circuit PA 1 and an output end of the second single-band primary amplification circuit PA 2 each are coupled to an output end of the dual-band shared secondary amplification circuit PA 3 via one first impedance inverter network INV 1 and then coupled to the second impedance transformation network INV 2. The first single-band primary amplification circuit PA 1 and the dual-band shared secondary amplification circuit PA 3 may form a Doherty architecture about the first frequency band via the corresponding first impedance inverter network INV 1 and the second impedance transformation network INV 2. The second single-band primary amplification circuit PA 2 and the dual-band shared secondary amplification circuit PA 3 may form a Doherty architecture about the second frequency band via the corresponding first impedance inverter network INV 1 and the second impedance transformation network INV 2. In this embodiment of this application, the third power amplification circuit 200C shown in FIG. 6 may be used to avoid a problem that a primary circuit enters a saturation region in advance due to interaction between concurrent signals in a concurrency scenario, and resolve problems of deterioration of saturation power, efficiency, and linear in the concurrency scenario. However, in a design of a high-power broadband power amplifier, an open-circuit characteristic of a secondary amplification circuit significantly increases a design difficulty. In addition, an output of a wideband single-output solution needs to be connected to a broadband isolator, while it is difficult for the current design of the broadband isolator to achieve good performance.

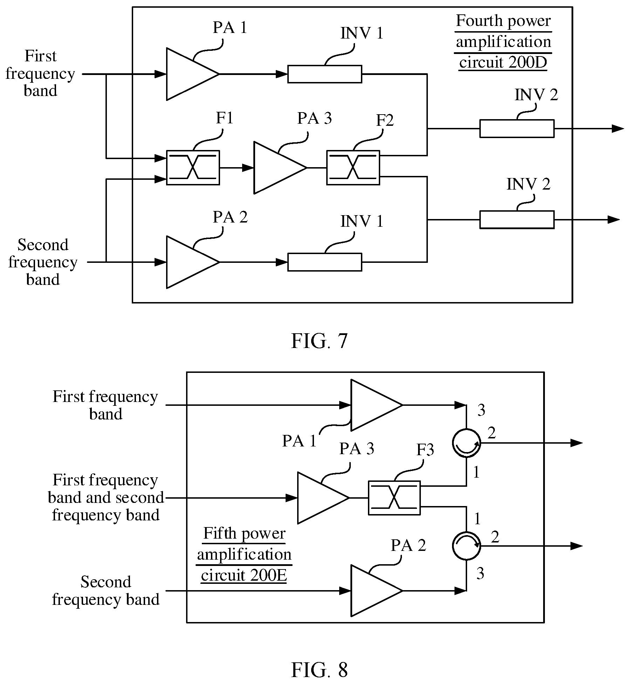

In some possible implementations, the power amplification circuit 200 may be a fourth power amplification circuit based on a secondary-sharing dual-band dual-output Doherty architecture. As shown in FIG. 7, the fourth power amplification circuit 200D includes a first single-band primary amplification circuit PA 1, a second single-band primary amplification circuit PA 2, a dual-band shared secondary amplification circuit PA 3, two first impedance inverter networks INV 1, two second impedance transformation networks INV 2, a front-end inter-frequency power splitter F1, and a back-end inter-frequency power splitter F2. The first single-band primary amplification circuit PA 1 and the second single-band primary amplification circuit PA 2 separately operate in class AB, and the dual-band shared secondary amplification circuit PA 3 operates in class C. Two splitting ends of the front-end inter-frequency power splitter F1 respectively input radio frequency signals of a first frequency band and a second frequency band, and a combining end of the front-end inter-frequency power splitter F1 outputs the radio frequency signals of the first frequency band and the second frequency band to an input end of the dual-band shared secondary amplification circuit PA 3. An output end of the dual-band shared secondary amplification circuit PA 3 outputs amplified radio frequency signals of the first frequency band and the second frequency band to a combining end of the back-end inter-frequency power splitter F2. An output end of the first single-band primary amplification circuit PA 1 and an output end of the second single-band primary amplification circuit PA 2 each are coupled to one first impedance inverter network INV 1, and the output end of the first single-band primary amplification circuit PA 1 and the output end of the second single-band primary amplification circuit PA 2 are respectively coupled to two splitting ends of the back-end inter-frequency power splitter F2 via the corresponding first impedance inverter networks INV 1. One splitting end of the back-end inter-frequency power splitter F2 outputs a radio frequency signal of the first frequency band to the first impedance inverter network INV 1 corresponding to the first single-band primary amplification circuit PA 1, to form a Doherty architecture with a corresponding second impedance transformation network INV 2 to perform power combination on the radio frequency signal of the first frequency band; and the other splitting end of the back-end inter-frequency power splitter F2 outputs a radio frequency signal of the second frequency band to the first impedance inverter network INV 1 corresponding to the second single-band primary amplification circuit PA 2, to form a Doherty architecture with a corresponding second impedance transformation network INV 2 to perform power combination on the radio frequency signal of the second frequency band. In this embodiment of this application, in the architecture shown in FIG. 7, the inter-frequency power splitter is used to implement dual outputs of different frequency bands of the secondary amplification circuit. In the wideband dual-output solution, a power amplifier output signal in a communication system may be connected to antennas by using two narrowband isolators, thereby reducing impact of a broadband isolator on link performance. However, in this architecture, the inter-frequency power splitter not only needs to meet an inter-frequency power splitting characteristic, but also needs to participate in load pull of radio frequency signals of two frequency bands, which increases a design difficulty. In addition, an insertion loss causes solution performance deterioration, making the design more difficult. Furthermore, an open-circuit characteristic problem of the secondary amplification circuit is still a design difficulty.

In some possible implementations, the power amplification circuit 200 may be a fifth power amplification circuit based on a circulator load modulated amplifier (circulator load modulated amplifier, CLMA). As shown in FIG. 8, the fifth power amplification circuit 200E includes a first single-band primary amplification circuit PA 1, a second single-band primary amplification circuit PA 2, a dual-band shared secondary amplification circuit PA 3, an inter-frequency power splitter F3, a first frequency band circulator C1, and a second frequency band circulator C2. The first single-band primary amplification circuit PA 1 and the second single-band primary amplification circuit PA 2 separately operate in class AB, and the dual-band shared secondary amplification circuit PA 3 operates in class C. An output end of the dual-band shared secondary amplification circuit PA 3 outputs amplified radio frequency signals of a first frequency band and a second frequency band to a combining end of the inter-frequency power splitter F3. A radio frequency signal that is of the first frequency band and that is amplified through a secondary circuit is output to a first end of the first frequency band circulator C1 through one splitting end of the inter-frequency power splitter F3, and a radio frequency signal that is of the second frequency band and that is amplified through a secondary circuit is output to a first end of the second frequency band circulator C2 through another splitting end of the inter-frequency power splitter F3. A radio frequency signal that is of the first frequency band and that is amplified through a primary circuit is input, from the first single-band primary amplification circuit PA 1, to a third end of the first frequency band circulator C1. A radio frequency signal that is of the second frequency band and that is amplified through a primary circuit is input, from the second single-band primary amplification circuit PA 2, to a third end of the second frequency band circulator C2. Because signal transmission inside the circulator is directional, a radio frequency signal of the first frequency band obtained through power combination may be output from a second end of the first frequency band circulator C1, and a radio frequency signal of the second frequency band obtained through power combination may be output from a second end of the second frequency band circulator C2. In the architecture shown in FIG. 8 in this application, the circulator is used as a combiner during power combination. Because impedance of an isolation end of the circulator is constant, impedance does not change with a change of load pull, thereby effectively avoiding an open-circuit characteristic problem of a secondary circuit. However, in this architecture, a design of the inter-frequency power splitter F3 needs to consider indicators such as out-of-band suppression and an insertion loss, which is of great difficulty.

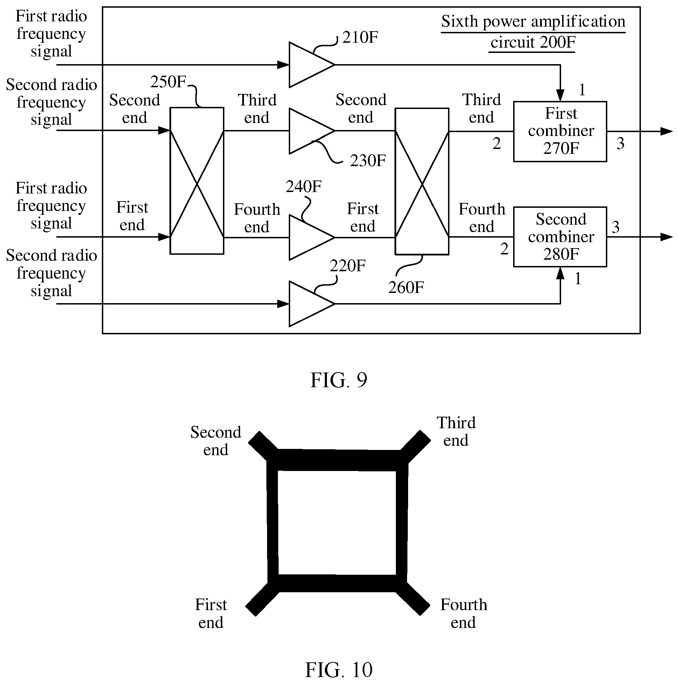

In some possible implementations, the power amplification circuit 200 may be a sixth power amplifier of a multi-frequency multi-output structure that implements inter-frequency power splitting based on a coupler. As shown in FIG. 9, the sixth power amplification circuit 200F includes a first primary amplification circuit 210F, a second primary amplification circuit 220F, a first secondary amplification circuit 230F, a second secondary amplification circuit 240F, a first coupler 250F, a second coupler 260F, a first combiner 270F, and a second combiner 280F. In the first coupler 250F and the second coupler 260F, there is a through path between a first end and a fourth end, there is a through path between a second end and a third end, there is an isolation path between the first end and the second end, there is an isolation path between the third end and the fourth end, and a phase difference of 90° exists between a radio frequency signal output by the third end and a radio frequency signal output by the fourth end.

In some examples, the coupler may be a crossed broadside coupler, a branch-line coupler, a parallel broadside coupler, or the like. The branch-line coupler is used as an example. A third end and a fourth end of the coupler respectively output a radio frequency signal whose phase is shifted by 180° and a radio frequency signal whose phase is shifted by 90°. The crossed broadside coupler is used as an example. A third end and a fourth end of the coupler respectively output a radio frequency signal whose phase is shifted by 90° and a radio frequency signal whose phase is not shifted. All these couplers can meet that a phase difference of 90° exists between the third end and the fourth end. During actual application, whether a connection relationship of the coupler is a connection relationship recorded in this solution is determined based on connection of end locations of coupling ends, through ends, and the like, instead of being determined based on a relative connection direction between ends on a same side of the coupler. Subsequent embodiments of this application are described according to a principle of the branch-line coupler. FIG. 10 shows an example structure of a branch-line coupler. In the figure, there is a through path between a first end and a fourth end of the coupler, there is a through path between a second end and a third end of the coupler, there is an isolation path between the first end and the second end of the coupler, and there is an isolation path between the third end and the fourth end of the coupler. Two ends of a through path are through ends of each other, two ends of an isolation path are isolation ends of each other, and two ends that are connected through a through path and an isolation path are coupling ends of each other. Therefore, the first end and the second end of the coupler are isolation ends of each other, and the first end and the fourth end of the coupler are through ends of each other. Between two ends that are through ends of each other, a signal is phase-shifted by 90° and then transmitted. Between two ends that are coupling ends of each other, a signal is phase-shifted by 180° and then output. At two ends that are isolation ends of each other, signals are canceled, and signals between the isolation ends cannot be output. A bandwidth of the first primary amplification circuit 210F and a bandwidth of the second primary amplification circuit 220F are less than a bandwidth of the first secondary amplification circuit 230F and a bandwidth of the second secondary amplification circuit 240F.

A third end of the first coupler 250F is coupled to a second end of the second coupler 260F by using the first secondary amplification circuit 230F, and a fourth end of the first coupler 260F is coupled to a first end of the second coupler 260F by using the second secondary amplification circuit 240F.

An output end of the first primary amplification circuit 210F is coupled to a first end of the first combiner 270F, a third end of the second coupler 260F is coupled to a second end of the first combiner 270F, an output end of the second primary amplification circuit 220F is coupled to a first end of the second combiner 280F, and a fourth end of the second coupler 260F is coupled to a second end of the second combiner 280F.

A first end of the first coupler 250F and an input end of the first primary amplification circuit 210F each are configured to receive a first radio frequency signal, a second end of the first coupler 250F and an input end of the second primary amplification circuit 220F each are configured to receive a second radio frequency signal, a frequency band of the first radio frequency signal is different from a frequency band of the second radio frequency signal, and a third end of the first combiner 270F and a third end of the second combiner 280F each are configured to output a combined radio frequency signal.

For example, as shown in FIG. 9, an example in which the first end of the first coupler 250F is an input end is used. When the first radio frequency signal is input to the first end, the third end of the first coupler 250F, as a coupling end of the first end, outputs a first radio frequency signal whose phase changes by 180°, and the fourth end of the first coupler 250F, as a through end of the first end, outputs a first radio frequency signal whose phase changes by 90°, the two radio frequency signals are transmitted to the second coupler 260F after respectively passing through the first secondary amplification circuit 230F and the second secondary amplification circuit 240F. A first radio frequency signal whose phase changes by 90° is input to the first end of the second coupler 260F, a 180° first radio frequency signal is obtained at the fourth end of the second coupler 260F, and a 270° first radio frequency signal is obtained at the third end of the second coupler 260F. A first radio frequency signal whose phase changes by 180° is input to the second end of the second coupler 260F, a 360° first radio frequency signal is obtained at the fourth end of the second coupler 260F, and a 270° first radio frequency signal is obtained at the third end of the second coupler 260F. Therefore, there are the 180° first radio frequency signal and the 360° first radio frequency signal at the fourth end of the second coupler 260F, and the two first radio frequency signals whose phases are opposite to each other cancel each other. There are the two 270° first radio frequency signals at the third end of the second coupler 260F, and the two 270° first radio frequency signals are superposed into one 270° first radio frequency signal. Therefore, when the first radio frequency signal is input to the first end of the first coupler 250F, only one first radio frequency signal whose phase is shifted by 270° is output from the third end of the second coupler 260F. Similarly, when the second radio frequency signal is input to the second end of the first coupler 250F, only a second radio frequency signal whose phase is shifted by 270° is output from the fourth end of the second coupler 260F. Therefore, the first coupler 250F and the second coupler 260F may form an inter-frequency power splitting structure.

In the embodiment shown in FIG. 9 in this application: First, the bandwidth of the first primary amplification circuit 210F and the bandwidth of the second primary amplification circuit 220F are set to be less than the bandwidth of the first secondary amplification circuit 230F and the bandwidth of the second secondary amplification circuit 240F. By designing bandwidths of the two primary circuits to be narrowband, the two primary circuits can function as two narrow-bandwidth power amplification units. Reducing a hardware design bandwidth facilitates narrowband impedance convergence, which helps improve ultimate performance. In addition, in a concurrency scenario, two primary amplification circuits operate on respective frequency bands, so that a VBW problem is avoided, and problems of deterioration of power, efficiency, and linear performance in the concurrency scenario can be resolved. Second, the first coupler 250F and the second coupler 260F form an inter-frequency power splitting structure. In comparison with the solution in which the inter-frequency power splitter F3 is used to split radio frequency signals of different frequency bands, the inter-frequency power splitting structure may have better out-of-band isolation and a smaller insertion loss, improving design solution efficiency and improving link linear performance. Third, radio frequency signals of different frequency bands are split into two radio frequency signals: the first radio frequency signal and the second radio frequency signal, and a dual-output architecture with two outputs of the second coupler 260F may be used to avoid problems of a large insertion loss and poor linearity caused by use of a broadband isolator. Fourth, a power sharing structure including a primary circuit and a secondary circuit may improve a back-off rate of a power amplifier and improve power efficiency, to implement a power amplifier energy-saving characteristic and reduce solution costs. In this embodiment of this application, as shown in FIG. 9, a design of a power amplifier with a large back-off amount, a large bandwidth, and high operating efficiency may be more easily implemented.

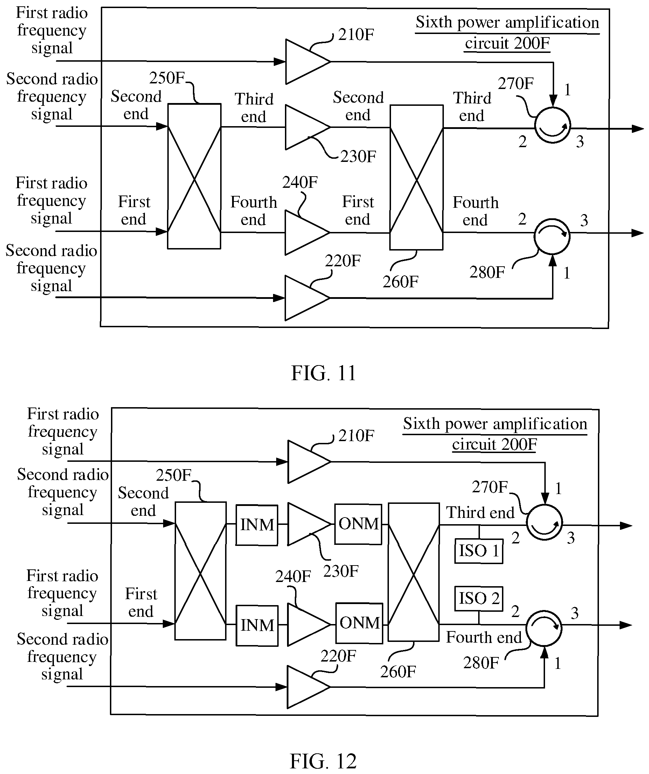

In some possible implementations, as shown in FIG. 11, the first combiner 270F and the second combiner 280F each are a circulator. In the circulator, a radio frequency signal is transmitted in a flow direction of a first end 1, a second end 2, and a third end 3 of the circulator. The third end of the first combiner 270F is configured to output a first combined radio frequency signal; the third end of the second combiner 280F is configured to output a second combined radio frequency signal; the first combined radio frequency signal is a combined signal of the first radio frequency signal; and the second combined radio frequency signal is a combined signal of the second radio frequency signal. In this embodiment of this application, the circulator is used as the first combiner 270F and the second combiner 280F that are disposed between the second coupler 260F and the primary circuit. Impedance of the circulator is stable, so that impedance conversion impact caused when power combination is performed between different amplification branches can be avoided, making designs of primary amplification circuits independent of each other, and making it easier to extend each branch into a structure of a plurality of amplification circuits, to obtain a larger power back-off amount.

In some examples, in the embodiment shown in FIG. 11, a minimum turn-on operating power point of the first primary amplification circuit 210F is lower than a minimum turn-on operating power point of the first secondary amplification circuit 230F, a minimum turn-on operating power point of the second primary amplification circuit 220F is lower than the minimum turn-on operating power point of the first secondary amplification circuit 230F, and the minimum turn-on operating power point of the first secondary amplification circuit 230F is lower than a minimum turn-on operating power point of the second secondary amplification circuit 240F. In this embodiment of this application, based on a design of the sixth power amplification circuit 200F, corresponding amplification circuits are turned on to perform power combination on input radio frequency signals in different power stages. Therefore, each amplification circuit corresponds to a minimum turn-on operating power point. A value relationship of minimum turn-on operating power points represents a turn-on sequence of different amplification circuits as power changes of input radio frequency signals.

For example, when the minimum turn-on operating power point of the first secondary amplification circuit 230F is lower than the minimum turn-on operating power point of the second secondary amplification circuit 240F, and only the first radio frequency signal is input to the sixth power amplification circuit 200F is used, the following applies: The first primary amplification circuit 210F operates in class AB, the first secondary amplification circuit 230F and the second secondary amplification circuit 240F may operate in class C, and the second primary amplification circuit 220F may be considered as turned off. Because the minimum turn-on operating power point of the first secondary amplification circuit 230F is lower than the minimum turn-on operating power point of the second secondary amplification circuit 240F, it may be considered that the first secondary amplification circuit 230F operates in shallow class C and the second secondary amplification circuit 240F operates in deep class C. In this case, the first primary amplification circuit 210F is at an isolation end of the first combiner 270F that is a circulator, and forms the foregoing CLMA architecture-based principle with the first secondary amplification circuit 230F and the second secondary amplification circuit 240F. A phase of the first radio frequency signal output by the second secondary amplification circuit 240F is 90° greater than a phase of the first radio frequency signal output by the first secondary amplification circuit 230F. The first radio frequency signal is output only at the third end of the second coupler 260F according to a DHT architecture-based operating mechanism formed by the first secondary amplification circuit 230F and the second secondary amplification circuit 240F.

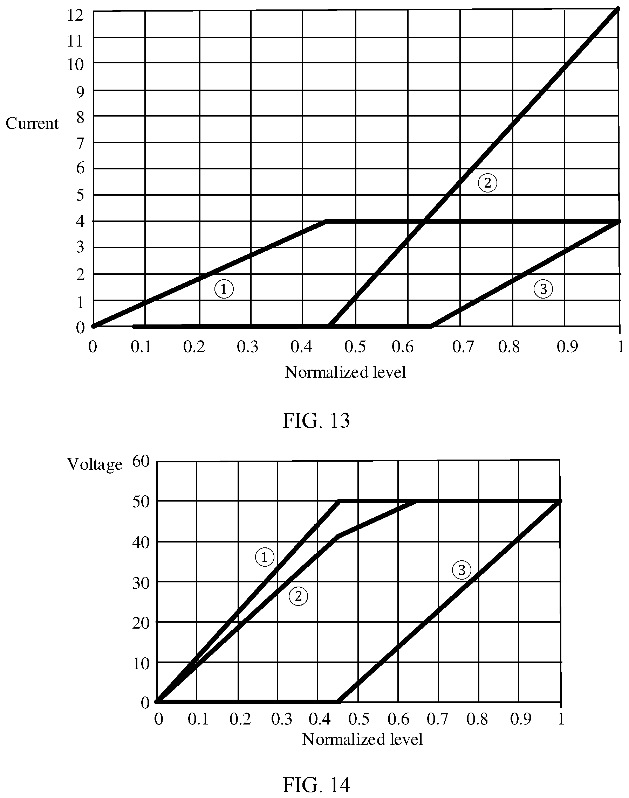

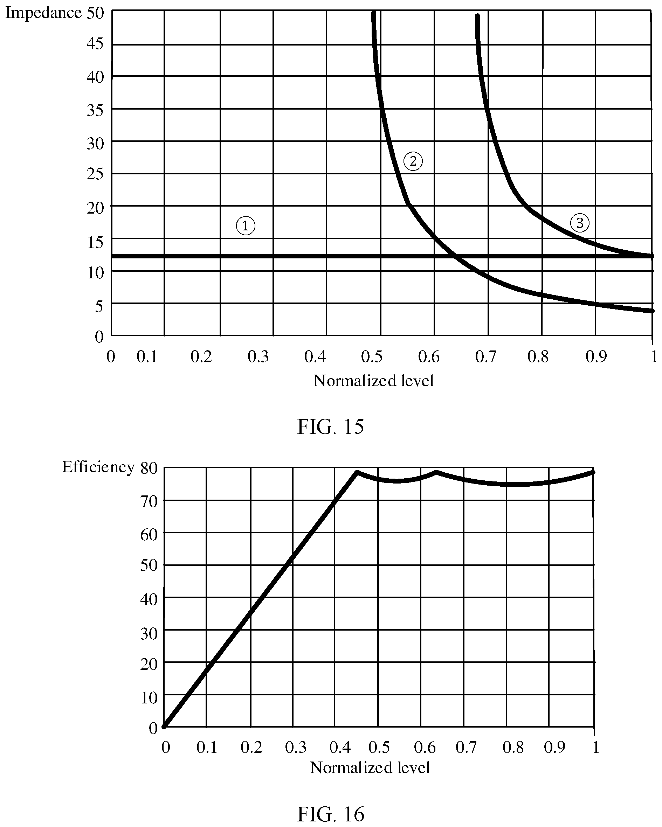

FIG. 13 shows a current change of each amplification branch as a power change of an input first radio frequency signal based on the embodiment shown in FIG. 11. FIG. 14 shows a voltage change of each amplification branch as a power change of an input first radio frequency signal based on the embodiment shown in FIG. 11. FIG. 15 shows an impedance change of each amplification branch as a power change of an input first radio frequency signal based on the embodiment shown in FIG. 11. In the figure, a line ①, a line ②, and a line ③ respectively represent the first primary amplification circuit 210F, the first secondary amplification circuit 230F, and the second secondary amplification circuit 240F. FIG. 16 is a diagram of power efficiency obtained, based on the embodiment shown in FIG. 11, as parameters in FIG. 13, FIG. 14, and FIG. 15 change. In the figure, a normalized level represents a signal power range of an input radio frequency signal. As shown in FIG. 13, FIG. 14, FIG. 15, and FIG. 16, when the first radio frequency signal is in a low-power interval, the first secondary amplification circuit 230F and the second secondary amplification circuit 240F are turned off, only the first primary amplification circuit 210F is turned on, and a power saturation point of the low-power interval is reached as a signal power of the input first radio frequency signal increases. When the first radio frequency signal is in a medium-power interval, the second secondary amplification circuit 240F is turned off, the first primary amplification circuit 210F and the first secondary amplification circuit 230F are turned on, the first primary amplification circuit 210F maintains in a saturated operating state, and the first secondary amplification circuit 230F tends to be voltage saturated as the power of the input first radio frequency signal increases, to reach an efficient operating state. When the first radio frequency signal is in a high-power interval, the first primary amplification circuit 210F, the first secondary amplification circuit 230F, and the second secondary amplification circuit 240F operate simultaneously. As the power of the input first radio frequency signal increases, the second secondary amplification circuit 240F also gradually reaches maximum operating efficiency. It can be learned from FIG. 16 that the sixth power amplification circuit 200F shown in FIG. 11 may have three power saturation points, have a large power back-off amount, and may maintain high operating efficiency at the power saturation point to achieve energy saving. For a related effect diagram of the second radio frequency signal, refer to the effect diagram of the first radio frequency signal. Details are not described herein again.

For example, when the minimum turn-on operating power point of the first secondary amplification circuit 230F is lower than the minimum turn-on operating power point of the second secondary amplification circuit 240F, for technical principles and beneficial effects of the case where the sixth power amplification circuit 200F receives only the second radio frequency, refer to the foregoing descriptions of the case where only the first radio frequency signal is received. Details are not described herein again.

For example, when the minimum turn-on operating power point of the first secondary amplification circuit 230F is lower than the minimum turn-on operating power point of the second secondary amplification circuit 240F, and both the first radio frequency signal and the second radio frequency signal are input to the sixth power amplification circuit 200F is used, the following applies: After the first radio frequency signal and the second radio frequency signal are transmitted through the first coupler 250F and the second coupler 260F, first radio frequency signals amplified by using the first secondary amplification circuit 230F and the second secondary amplification circuit 240F are canceled at the fourth end of the second coupler 260F and are combined at the third end of the second coupler 260F, so that the first radio frequency signal is output at the third end of the second coupler 260F. Similarly, second radio frequency signals amplified by using the first secondary amplification circuit 230F and the second secondary amplification circuit 240F are output at the fourth end of the second coupler 260F. Therefore, in the architecture shown in FIG. 9, the first radio frequency signal and the second radio frequency signal of different frequency bands may be transmitted in the sixth power amplification circuit 200F without affecting each other. The first secondary amplification circuit 230F and the second secondary amplification circuit 240F may be used as power amplifiers shared by the first radio frequency signal and the second radio frequency signal. In this architecture, the first primary amplification circuit 210F and the second primary amplification circuit 220F may be designed in a manner of narrowing bandwidths. In this solution, a power amplifier with a plurality of frequency bands, a large bandwidth, a large back-off amount, and high efficiency may be more easily implemented. In some examples, as shown in FIG. 12, when the first secondary amplification circuit 230F and the second secondary amplification circuit 240F have different minimum turn-on operating power points, to improve performance of an inter-frequency power splitting function, a first isolation circuit ISO 1 may be coupled to the third end of the second coupler 260F, and a second isolation circuit ISO 2 may be coupled to the fourth end of the second coupler 260F. The first isolation circuit ISO 1 is configured to implement an open circuit for the first radio frequency signal and implement a short circuit for the second radio frequency signal. The second isolation circuit ISO 2 is configured to implement an open circuit for the second radio frequency signal and implement a short circuit for the first radio frequency signal. The first isolation circuit ISO 1 and the second isolation circuit ISO 2 may be disposed to absorb a signal of another frequency band, thereby improving an inter-frequency power splitting characteristic. In some examples, to ensure signal transmission quality, impedance matching networks may be disposed on different amplification branches. For example, as shown in FIG. 12, output matching networks OMNs may be disposed between the first secondary amplification circuit 230F and the second coupler 260F, and between the second secondary amplification circuit 240F and the second coupler 260F, respectively. Input matching networks IMNs may be disposed between the first coupler 250F and the first secondary amplification circuit 230F, and between the first coupler 250F and the second secondary amplification circuit 240F, respectively.

For example, in the embodiment shown in FIG. 11, a minimum turn-on operating power point of the first primary amplification circuit 210F is lower than a minimum turn-on operating power point of the first secondary amplification circuit 230F, a minimum turn-on operating power point of the second primary amplification circuit 220F is lower than the minimum turn-on operating power point of the first secondary amplification circuit 230F, and the minimum turn-on operating power point of the first secondary amplification circuit 230F is equal to a minimum turn-on operating power point of the second secondary amplification circuit 240F.

For example, when a minimum turn-on operating power point of the first secondary amplification circuit 230F is higher than a minimum turn-on operating power point of the second secondary amplification circuit 240F, the first secondary amplification circuit 230F is turned on after the second secondary amplification circuit 240F as a power of an input radio frequency signal increases. In this solution, a turn-on sequence of the first secondary amplification circuit 230F and the second secondary amplification circuit 240F is opposite to that in the case in which the minimum turn-on operating power point of the first secondary amplification circuit 230F is lower than the minimum turn-on operating power point of the second secondary amplification circuit 240F. For specific descriptions, refer to the descriptions in which the minimum turn-on operating power point of the first secondary amplification circuit 230F is higher than the minimum turn-on operating power point of the second secondary amplification circuit 240F. Details are not described herein again.

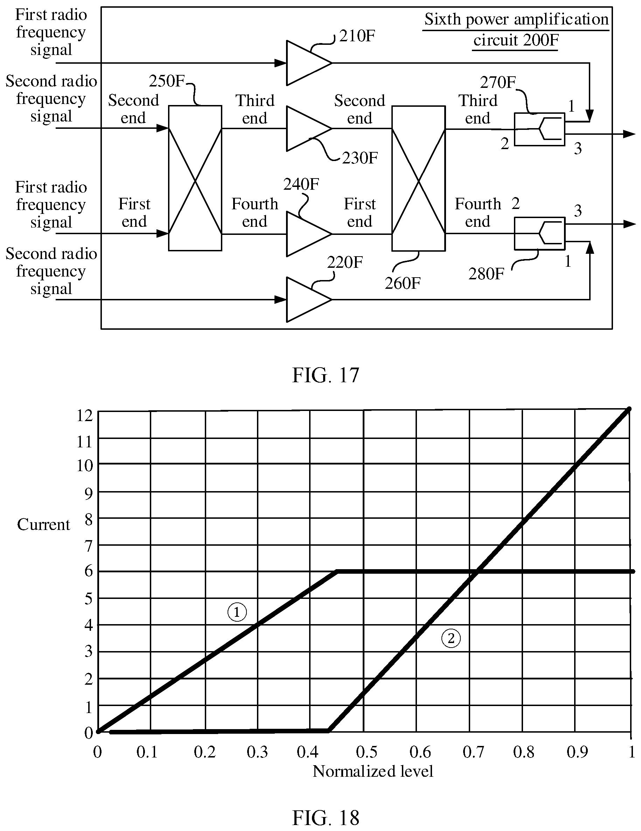

In some possible implementations, as shown in FIG. 17, the first ends and the third ends of the first combiner 270F and the second combiner 280F are splitting ends of the inter-frequency power splitters, and the second ends of the first combiner 270F and the second combiner 280F are combining ends of the inter-frequency power splitters. The first end of the first combiner 270F presents band-pass for the first radio frequency signal and presents band-stop for the second radio frequency signal, the third end of the first combiner 270F presents band-pass for the second radio frequency signal and presents band-stop for the first radio frequency signal, the second end of the first combiner 270F presents band-pass for the first radio frequency signal and the second radio frequency signal, and the third end of the first combiner 270F is configured to output a second combined radio frequency signal. The first end of the second combiner 280F presents band-pass for the second radio frequency signal and presents band-stop for the first radio frequency signal, the third end of the first combiner 270F presents band-pass for the first radio frequency signal and presents band-stop for the second radio frequency signal, the second end of the second combiner 280F presents band-pass for the first radio frequency signal and the second radio frequency signal, and the third end of the second combiner 280F is configured to output a first combined radio frequency signal.

For example, in the embodiment shown in FIG. 17, a minimum turn-on operating power point of the first primary amplification circuit 210F is lower than a minimum turn-on operating power point of the first secondary amplification circuit 240F, a minimum turn-on operating power point of the second primary amplification circuit 220F is lower than the minimum turn-on operating power point of the first secondary amplification circuit 240F, and the minimum turn-on operating power point of the first secondary amplification circuit 240F may be lower than, equal to, or higher than a minimum turn-on operating power point of the second secondary amplification circuit 240F. In this case, the first primary amplification circuit 210F and the second primary amplification circuit 220F operate in class AB, and the first secondary amplification circuit 230F and the second secondary amplification circuit 240F operate in class C.

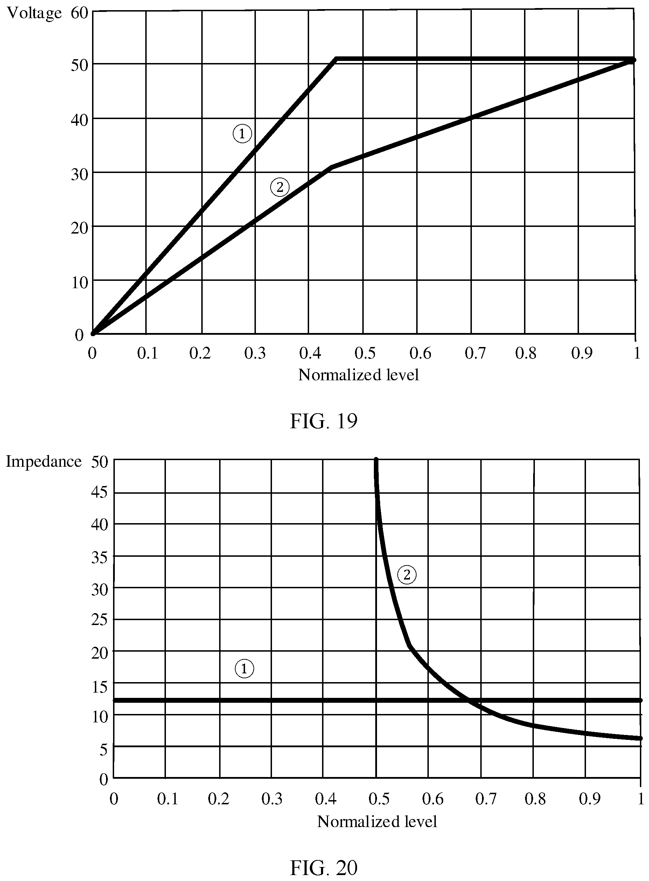

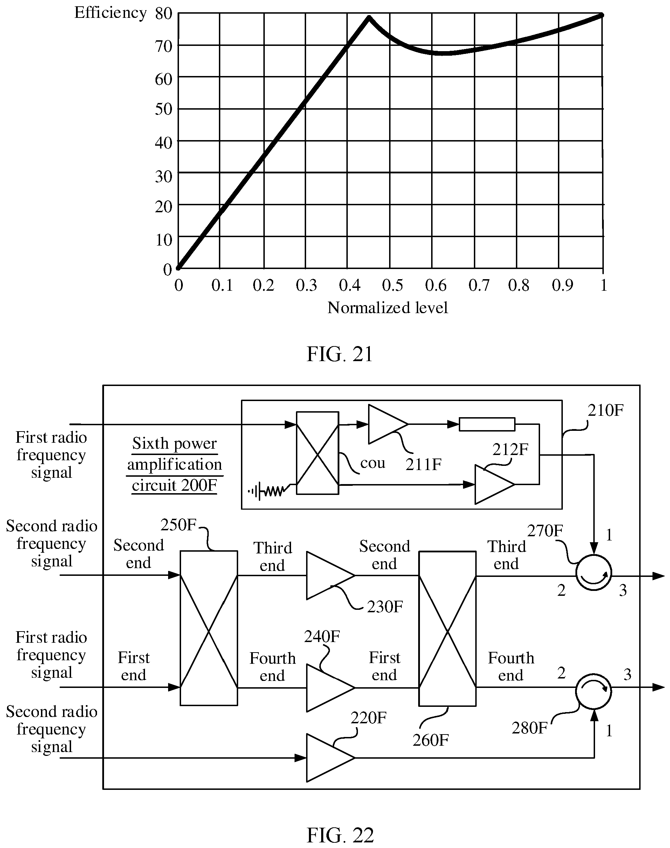

For example, the sixth power amplification circuit 200F receives only the first radio frequency signal. As shown in FIG. 17, the second primary amplification circuit 220F is turned off, the first primary amplification circuit 210F operates in class A, and the first secondary amplification circuit 230F and the second secondary amplification circuit 240F operate in class C. The first combiner 270F is an inter-frequency power splitter. The first end of the first combiner 270F presents band-pass for the first radio frequency signal and presents band-stop for the second radio frequency signal, the third end of the first combiner 270F presents band-pass for the second radio frequency signal and presents band-stop for the first radio frequency signal, and the second end of the first combiner 270F presents band-pass for the first radio frequency signal and the second radio frequency signal. The first end of the second combiner 280F presents band-pass for the second radio frequency signal and presents band-stop for the first radio frequency signal, the third end of the second combiner 280F presents band-pass for the first radio frequency signal and presents band-stop for the second radio frequency signal, and the second end of the second combiner 280F presents band-pass for the first radio frequency signal and the second radio frequency signal. An output signal of the first primary amplification circuit 210F is coupled to the first end of the first combiner 270F, flows through the second end of the first combiner 270F to the third end of the second coupler 260F, is combined with the first secondary amplification circuit 230F and the second secondary amplification circuit 240F through the second coupler 260F, then output from the fourth end of the second coupler 260F to the second combiner 280F that is an inter-frequency power splitter, and then flows from the second end of the second combiner 280F to the third end of the second combiner 280F and is output. In this case, the first primary amplification circuit 210F, the first secondary amplification circuit 230F, and the second secondary amplification circuit 240F may form an SLMBA architecture. FIG. 18 shows a current change of each amplification branch as a power change of an input first radio frequency signal based on the embodiment shown in FIG. 17. FIG. 19 shows a voltage change of each amplification branch as a power change of an input first radio frequency signal based on the embodiment shown in FIG. 17. FIG. 20 shows an impedance change of each amplification branch as a power change of an input first radio frequency signal based on the embodiment shown in FIG. 17. FIG. 21 is a diagram of power efficiency obtained, based on the embodiment shown in FIG. 17 as parameters in FIG. 18, FIG. 19, and FIG. 20 change. In the figure, a line ① represents the first primary amplification circuit 210F, and a line ② represents the first secondary amplification circuit 230F and the second secondary amplification circuits 240F that are used as balanced amplifiers. As shown in FIG. 18, FIG. 19, FIG. 20, and FIG. 21, when the first radio frequency signal is in a low-power interval, only the first primary amplification circuit 210F is turned on to operate. The first radio frequency signal is transmitted from the first primary amplification circuit 210F to the first end of the first combiner 270F, and is output from the second end of the first combiner 270F to the third end of the second coupler 260F, and then the first radio frequency signal is output through the fourth end of the second coupler 260F. After the first radio frequency signal is input to the second end of the second combiner 280F, the first radio frequency signal is output from the third end of the second combiner 280F. When the first radio frequency signal is in a high-power interval, the first primary amplification circuit 210F, the first secondary amplification circuit 230F, and the second secondary amplification circuit 240F are turned on simultaneously, and the first combined radio frequency signal is output from the third end of the second combiner 280F. For a related effect diagram of the second radio frequency signal, refer to the effect diagram of the first radio frequency signal. Details are not described herein again.

For example, when the minimum turn-on operating power point of the first secondary amplification circuit 240F is equal to the minimum turn-on operating power point of the second secondary amplification circuit 240F, the first secondary amplification circuit 240F and the second secondary amplification circuit 240F are turned on simultaneously. When the minimum turn-on operating power point of the first secondary amplification circuit 240F is lower than the minimum turn-on operating power point of the second secondary amplification circuit 240F, the first secondary amplification circuit 240F is turned on earlier than the second secondary amplification circuit 240F as a power of an input radio frequency signal increases. When the minimum turn-on operating power point of the first secondary amplification circuit 240F is lower than the minimum turn-on operating power point of the second secondary amplification circuit 240F, the first secondary amplification circuit 240F is turned on after the second secondary amplification circuit 240F as a power of an input radio frequency signal increases.

For example, for descriptions of technical principles and technical effects of the embodiment shown in FIG. 17 where the sixth power amplification circuit 200F receives only the second radio frequency signal, refer to the foregoing related descriptions of the embodiment shown in FIG. 17. Details are not described herein again.

For example, in the embodiment shown in FIG. 17, when the sixth power amplification circuit 200F receives both the first radio frequency signal and the second radio frequency signal, the two radio frequency signals of different frequency bands do not affect each other.

In the embodiment shown in FIG. 17 in this application, input and output procedures of an amplified first radio frequency signal based on a structure of a bridge and an inter-frequency power splitter are different from those based on a conventional power amplifier. By changing a transmission flow direction of a radio frequency signal and a combined radio frequency signal of a primary circuit, a transmission insertion loss can be reduced, power amplification performance can be improved, and an extended design of the sixth power amplification circuit 200F for a high power, a large bandwidth, a large back-off amount, and high efficiency can be more easily implemented.

For example, in the architectures shown in FIG. 11 and FIG. 17, at least one of the first primary amplification circuit 210F, the second primary amplification circuit 220F, the first secondary amplification circuit 230F, and the second secondary amplification circuit 240F may be extended into a power combining circuit. The power combining circuit includes a plurality of amplification branch circuits. By extending into a structure of the power combining circuit, a back-off amount of the sixth power amplification circuit 200F may be further extended.

For example, the power combining circuit includes at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation amplification circuit.

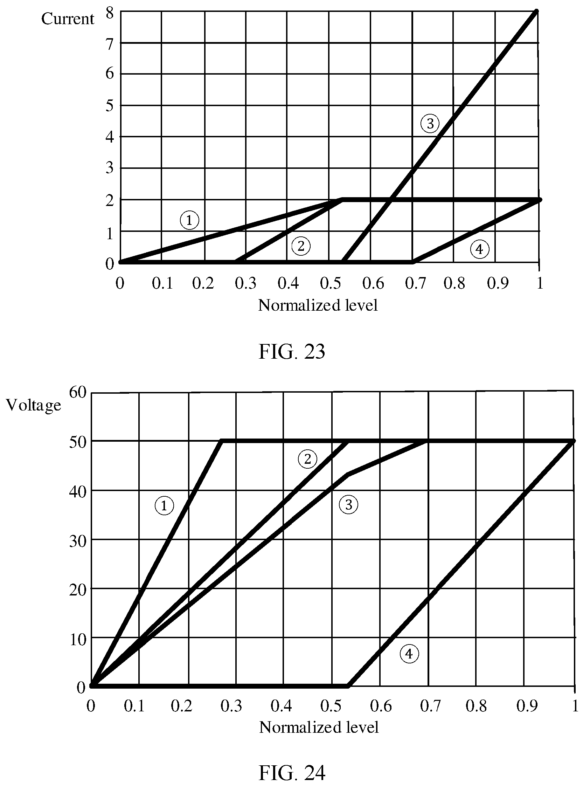

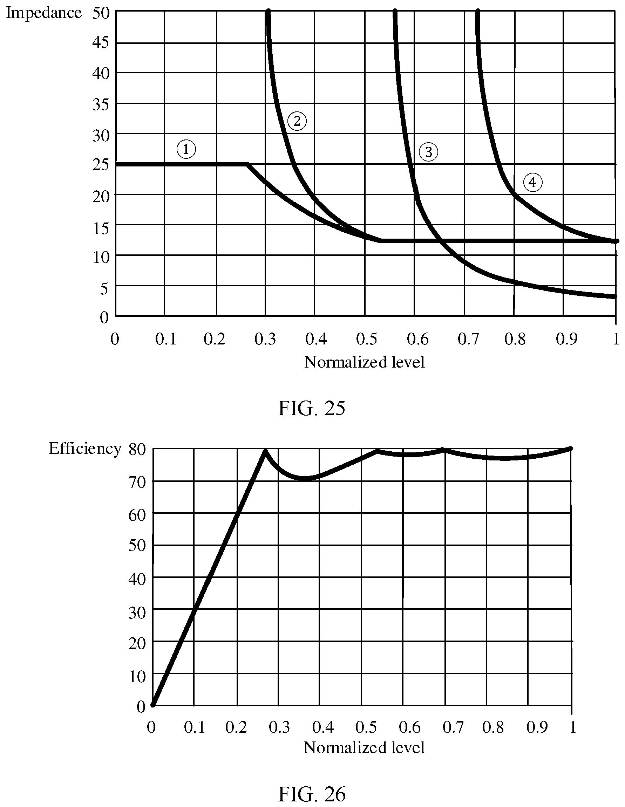

For example, the first primary amplification circuit 210F in the architecture shown in FIG. 11 is a power combining circuit, and the power combining circuit is an amplification circuit of a Doherty architecture. As shown in FIG. 22, a minimum turn-on operating power point of the first primary amplification circuit 210F is lower than a minimum turn-on operating power point of the first secondary amplification circuit 230F, and the minimum turn-on operating power point of the first secondary amplification circuit 230F is lower than a minimum turn-on operating power point of the second secondary amplification circuit 240F. In addition, the first primary amplification circuit 210F includes a primary amplifier 211F and a secondary amplifier 212F. A minimum turn-on operating power point of the primary amplifier 211F is lower than a minimum turn-on operating power point of the secondary amplifier 212F. In this case, it may be defined that the primary amplifier 211F operates in class AB, the secondary amplifier 212F operates in shallow class C, the first secondary amplification circuit 230F operates in class C, and the second secondary amplification circuit 240F operates in deep class C. FIG. 23 shows a current change of each amplification branch as a power change of an input first radio frequency signal based on the embodiment shown in FIG. 22. FIG. 24 shows a voltage change of each amplification branch as a power change of an input first radio frequency signal based on the embodiment shown in FIG. 22. FIG. 25 shows an impedance change of each amplification branch as a power change of an input first radio frequency signal based on the embodiment shown in FIG. 22. FIG. 26 is a diagram of power efficiency obtained, based on the embodiment shown in FIG. 22, as parameters in FIG. 23, FIG. 24, and FIG. 25 change. In the figure, a line ①, a line ②, a line ③, and a line ④ respectively represent the primary amplifier 211F of the first primary amplification circuit 210F, the secondary amplifier 212F of the first primary amplification circuit 210F, the first secondary amplification circuit 230F, and the second secondary amplification circuit 240F. As shown in FIG. 23, FIG. 24, FIG. 25, and FIG. 26, when the sixth power amplification circuit 200F receives only the first radio frequency signal, and when the first radio frequency signal is in a low-power interval, only the primary amplifier 211F is turned on to operate. As the power of the input first radio frequency signal increases, a voltage of a branch in which the primary amplifier 211F is located is saturated. When the first radio frequency signal is in a low-and-medium-power interval, the primary amplifier 211F and the secondary amplifier 212F are turned on to operate. As the power of the input first radio frequency signal increases, a voltage of a branch in which the primary amplifier 211F is located remains unchanged, and a current is saturated. Both a voltage and a current of the secondary amplifier 212F approach being saturated. When the first radio frequency signal is in a medium-and-high-power interval, the primary amplifier 211F, the secondary amplifier 212F, and the first secondary amplification circuit 230F are all turned on to operate, and a voltage of the first secondary amplification circuit 230F approaches being saturated. When the first radio frequency signal is in a high-power interval, the primary amplifier 211F, the secondary amplifier 212F, the first secondary amplification circuit 230F, and the second secondary amplification circuit 240F are all turned on to operate, and the second secondary amplification circuit 240F performs load-pull modulation on the first secondary amplification circuit 230F. As the power of the input first radio frequency signal increases, both the first secondary amplification circuit 230F and the second secondary amplification circuit 240F gradually reach a power saturation state. For a related effect diagram of the second radio frequency signal, refer to the effect diagram of the first radio frequency signal. Details are not described herein again.

For example, as shown in FIG. 22, in the first primary amplification circuit 210F, one first radio frequency signal may be split into one 0° first radio frequency signal and one 90° first radio frequency signal through a coupler cou, which are respectively input to the primary amplifier 211F and the secondary amplifier 212F. For example, first radio frequency signals may alternatively be respectively input to the primary amplifier 211F and the secondary amplifier 212F, and a phase compensation line is disposed at a front end of the secondary amplifier 212F, so that a first radio frequency signal whose phase is shifted by 90° may be input to the secondary amplifier 212F.

In this embodiment of this application, the first combiner 270F and the second combiner 280F are used in the architectures shown in FIG. 11 and FIG. 17. The first combiner 270F and the second combiner 280F enable the first primary amplification circuit 210F and the second primary amplification circuit 220F to have constant impedance and relatively independent designs. In this case, in the embodiments shown in FIG. 11 and FIG. 17, at least one of the first primary amplification circuit 210F, the second primary amplification circuit 220F, the first secondary amplification circuit 240F, and the second secondary amplification circuit 240F may be extended into a power combining circuit. By extending into a structure of the power combining circuit, a back-off amount of the sixth power amplification circuit 200F may be further extended. FIG. 22 is an example diagram of extending the first primary amplification circuit 210F in the embodiment shown in FIG. 11 into a structure with a larger power back-off amount. For related technical principles and technical effects of extending at least one of the second primary amplification circuit 220F, the first secondary amplification circuit 240F, and the second secondary amplification circuit 240F in the embodiment shown in FIG. 11 into a power combining circuit, and related technical principles and technical effects of extending at least one of the first primary amplification circuit 210F, the second primary amplification circuit 220F, the first secondary amplification circuit 240F, and the second secondary amplification circuit 240F in the embodiment shown in FIG. 17 into a power combining circuit, refer to related descriptions of the embodiment in FIG. 20. Details are not described herein again.

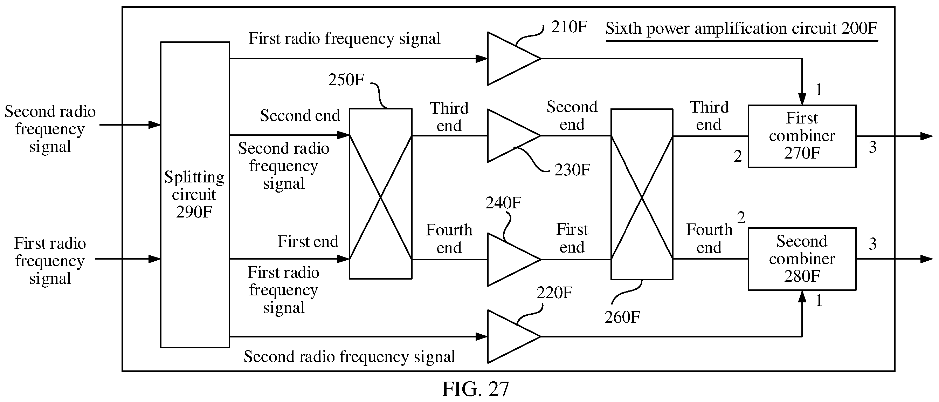

In some possible implementations, as shown in FIG. 27, based on the embodiments shown in FIG. 9, FIG. 11, FIG. 17, and FIG. 22, the sixth power amplification circuit 200F further includes a splitting circuit 290F. The splitting circuit 290F is configured to: receive the first radio frequency signal and the second radio frequency signal, separately output the first radio frequency signal to the input end of the first primary amplification circuit 210F and the first end of the first coupler 250F, and separately output the second radio frequency signal to the input end of the second primary amplification circuit 220F and the second end of the first coupler 250F.

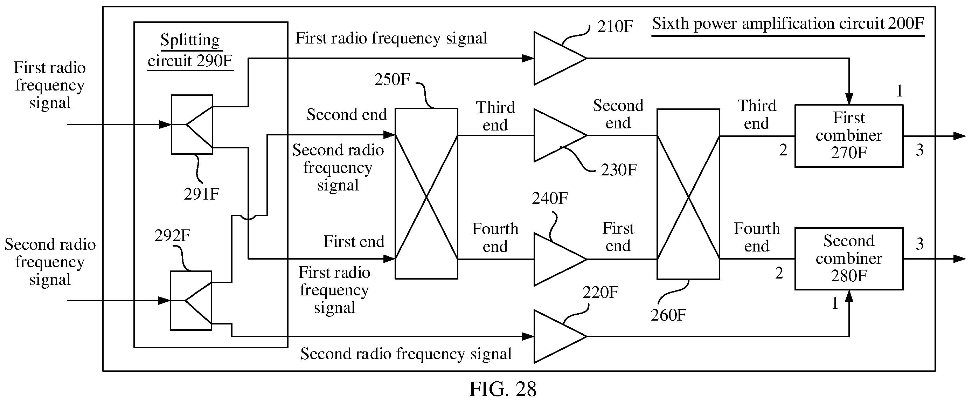

In some examples, as shown in FIG. 28, the splitting circuit 290F includes a first power splitter 291F and a second power splitter 292F. A combining end of the first power splitter 291F is configured to receive the first radio frequency signal. A first splitting end and a second splitting end of the first power splitter 291F are separately configured to output one first radio frequency signal. A combining end of the second power splitter 292F is configured to receive the second radio frequency signal. A first splitting end and a second splitting end of the second power splitter 292F are separately configured to output one second radio frequency signal.

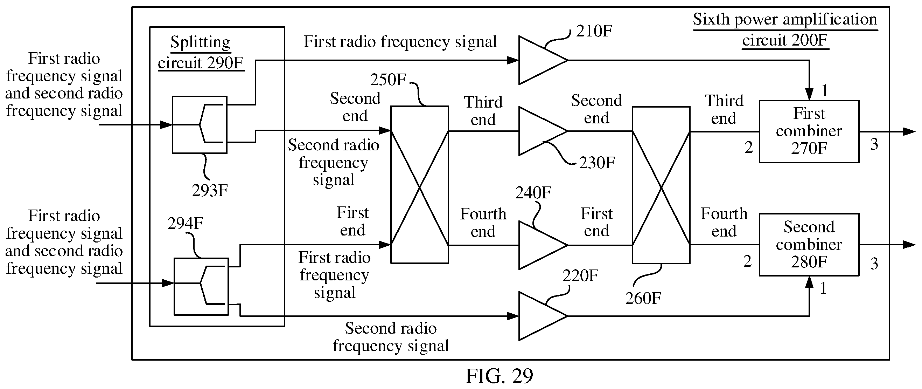

In some examples, as shown in FIG. 29, the splitting circuit 290F includes a first inter-frequency power splitter 293F and a second inter-frequency power splitter 294F. A combining end of the first inter-frequency power splitter 293F is configured to receive the first radio frequency signal and the second radio frequency signal, a first splitting end of the first inter-frequency power splitter 293F outputs one first radio frequency signal, and a second splitting end of the first inter-frequency power splitter 293F is configured to output one second radio frequency signal. A combining end of the second inter-frequency power splitter 294F is configured to receive the first radio frequency signal and the second radio frequency signal, a first splitting end of the second inter-frequency power splitter 294F outputs one first radio frequency signal, and a second splitting end of the second inter-frequency power splitter 294F is configured to output one second radio frequency signal. For example, as shown in FIG. 29, the first radio frequency signal and the second radio frequency signal that are output by the first inter-frequency power splitter 293F may be respectively provided to the first primary amplification circuit 210F and the first coupler 250F. The first radio frequency signal and the second radio frequency signal that are output by the second inter-frequency power splitter 294F may be respectively provided to the first coupler 250F and the second primary amplification circuit 220F. For example, the first radio frequency signal and the second radio frequency signal that are output by the first inter-frequency power splitter 293F may alternatively be respectively provided to the first primary amplification circuit 210F and the second primary amplification circuit 220F. The first radio frequency signal and the second radio frequency signal that are output by the second inter-frequency power splitter 294F are output to the first coupler 250F.

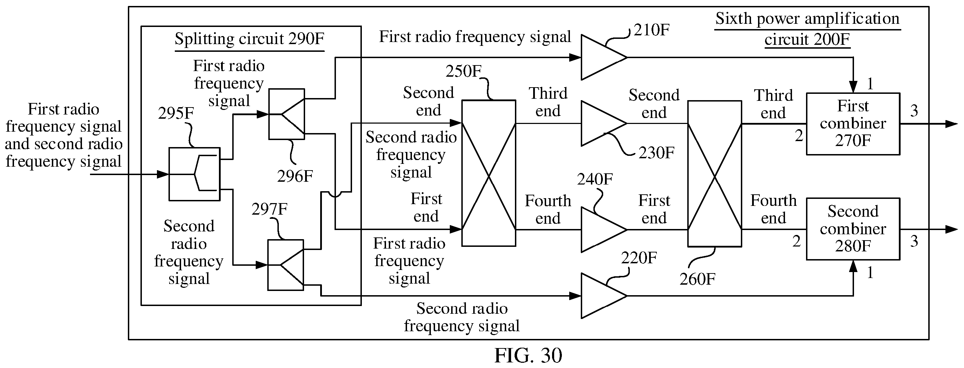

In some examples, as shown in FIG. 30, the splitting circuit 290F includes a third inter-frequency power splitter 295F, a third power splitter 296F, and a fourth power splitter 297F. A first splitting end and a second splitting end of the third inter-frequency power splitter 295F are respectively coupled to a combining end of the third power splitter 296F and a combining end of the fourth power splitter 297F. A combining end of the third inter-frequency power splitter 295F is configured to receive the first radio frequency signal and the second radio frequency signal, the first splitting end of the third inter-frequency power splitter 295F is configured to output the first radio frequency signal, and the second splitting end of the third inter-frequency power splitter 295F is configured to output the second radio frequency signal. A first splitting end and a second splitting end of the third power splitter 296F are separately configured to output one first radio frequency signal. A first splitting end and a second splitting end of the fourth power splitter 297F are separately configured to output one second radio frequency signal.

In this embodiment of this application, the sixth power amplification circuit 200F may split, by using the splitting circuit 290F, one input first radio frequency signal and one input second radio frequency signal into a plurality of signals, and output the plurality of signals to different amplification branches respectively for use. A splitting manner may be the implementations shown in FIG. 28, FIG. 29, and FIG. 30, or may be another splitting manner. This is not limited in this application.

In some possible implementations, the first radio frequency signal and the second radio frequency signal include a radio frequency signal of one or more sub-bands. In some examples, the first radio frequency signal may be in three low frequencies (for example, 700 MHz, 800 MHz, and 900 MHz), and the second radio frequency signal may be in three intermediate frequencies (for example, 1.8 GHz, 2.1 GHz, and 2.6 GHz). Alternatively, the first radio frequency signal and/or the second radio frequency signal may be in another frequency band. In some examples, the first radio frequency signal may be in the first one of the three low frequencies, and the second radio frequency signal may be in the other two of the three low frequencies. Alternatively, the first radio frequency signal may be in two of the three low frequencies, and the second radio frequency signal may be in the remaining one of the three low frequencies. In some examples, the first radio frequency signal may be in two frequencies of 1.8 GHz and 2.1 GHz in the three intermediate frequencies, and the second radio frequency signal may be in a single frequency of 2.6 GHz in the three intermediate frequencies. In this embodiment of this application, a design of splitting one primary circuit into two circuits with small relative bandwidths is used. For example, a relative bandwidth of three intermediate frequencies is 40%, and the three intermediate frequencies are split into two frequencies of 1.8 GHz and 2.1 GHz (with a relative bandwidth of 18%) and a single frequency of 2.6 GHz (with a relative bandwidth of 3%). A smaller relative bandwidth facilitates convergence of an impedance design, and efficiency of each amplification branch can be further improved, thereby improving back-off efficiency and full-load efficiency of the sixth power amplification circuit 200F.

Embodiments of this application provide a power amplification circuit, a radio frequency generation device, and a communication system. First, in the power amplification circuit, a dual coupler, equivalent to an inter-frequency power splitting structure, is used, and a design difficulty of a broadband isolator can be avoided when a combiner is coupled with two primary amplification circuits to implement dual outputs. Second, an equivalent bridge-based inter-frequency power splitting structure may be used to avoid a problem of poor out-of-band suppression and a high design difficulty caused by the use of an inter-frequency power splitter. Third, a bandwidth of a primary circuit is designed to be smaller than a bandwidth of a power sharing secondary circuit, so that the primary circuit can be split in a broadband power amplifier, effectively resolving a VBW design challenge in multi-frequency concurrency in the power amplification circuit, thereby improving concurrency efficiency and improving linearity. Fourth, in a design in which one original primary circuit is split into two primary circuits with smaller relative bandwidths, a relative bandwidth of each primary circuit is reduced, so that convergence of an impedance design is better, and efficiency of each design unit can be further improved, thereby improving back-off efficiency and full-load efficiency. Fifth, an inter-frequency power splitter, a circulator, or the like is used as a combiner, to implement relative stability between a primary circuit and a secondary circuit, so that an architecture of the primary circuit and/or the secondary circuit in the solution can be further extended, to obtain a power amplification architecture with a larger back-off amount.

Embodiments of this application further provide a chip system. The chip system includes at least one processor and at least one interface circuit. The at least one processor and the at least one interface circuit may be interconnected through a line. The processor is configured to support the chip system in implementing functions or steps in the foregoing method embodiments. The at least one interface circuit may be configured to receive a signal from another apparatus (for example, a communication interface, a radio frequency generation circuit, a power amplification circuit, or an antenna), or send a signal to another apparatus (for example, a communication interface, a radio frequency generation circuit, a power amplification circuit, or an antenna). The chip system may include a chip, and may further include another discrete component.

A controller in this embodiment of this application may be a chip. For example, the controller may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments. Details are not described herein again.

In the several embodiments provided in this application, it should be understood that the disclosed system, device, and method may be implemented in other manners. For example, the described device embodiment is merely an example. For example, division into modules is merely logical function division and may be other division during actual implementation. For example, a plurality of modules or components may be combined or may be integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed on a plurality of devices. A part or all of the modules may be selected based on actual requirements to achieve the objectives of the solutions of embodiments.

In addition, functional modules in embodiments of this application may be integrated into one device, or each of the modules may exist alone physically, or two or more modules are integrated into one device.

All or a part of the foregoing embodiments may be implemented by using software, hardware, firmware, or any combination thereof. When a software program is used to implement embodiments, all or a part of embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (Solid-State Disk, SSD)), or the like.

The communication system in embodiments of this application may be a device, for example, a terminal or a chip that may be used in the terminal, configured to implement a wireless communication function. The terminal may be UE, an access terminal, a terminal unit, a terminal station, a mobile station, a remote station, a remote terminal, a mobile device, a wireless communication device, a terminal agent, a terminal apparatus, or the like in a 6G network or a future evolved public land mobile network (public land mobile network, PLMN). The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a compute device or another processing device connected to a wireless modem, a vehicle-mounted device or a wearable device, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. Optionally, an electronic device and a transmitting apparatus may be mobile or fixed.

In a possible implementation, the communication system, the baseband processing device, and the radio frequency generation device in embodiments of this application may be network devices that communicate with the terminal device. The network device may include a transmission and reception point (transmission and reception point, TRP), a base station, a remote radio unit (remote radio unit, RRU) or a baseband unit (baseband unit, BBU) (which may also be referred to as a digital unit (digital unit, DU)) of a split base station, a satellite, an uncrewed aerial vehicle, a broadband network service gateway (broadband network gateway, BNG), an aggregation switch, a non-3GPP access device, a relay station, an access point, or the like.

In addition, the base station may be a base transceiver station (base transceiver station, BTS) in a global system for mobile communication (global system for mobile communication, GSM) or code division multiple access (code division multiple access, CDMA) network, an NB (NodeB) in wideband code division multiple access (wideband code division multiple access, WCDMA), an eNB or eNodeB (evolutional NodeB) in LTE, a radio controller in a cloud radio access network (cloud radio access network, CRAN) scenario, or a base station (for example, a next generation NodeB (gNodeB, gNB)) in a 5G communication system, a base station in a future evolved network, or the like. This is not specifically limited herein.

In addition, a communication architecture and a service scenario described in embodiments of this application are intended to describe the technical solutions in embodiments of this application more clearly, and do not constitute a limitation on the technical solutions provided in embodiments of this application. A person of ordinary skill in the art may know that with the evolution of the communication architecture and the emergence of new service scenarios, the technical solutions provided in embodiments of this application are also applicable to similar technical problems.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power amplification circuit, comprising a first primary amplification circuit, a second primary amplification circuit, a first secondary amplification circuit, a second secondary amplification circuit, a first coupler, a second coupler, a first combiner, and a second combiner, wherein in the first coupler and the second coupler, an isolation path is formed between a first end and a second end, a through path is formed between the first end and a fourth end, and a phase difference of 90° exists between a radio frequency signal output by a third end and a radio frequency signal output by the fourth end; and a bandwidth of the first primary amplification circuit and a bandwidth of the second primary amplification circuit are less than a bandwidth of the first secondary amplification circuit and a bandwidth of the second secondary amplification circuit, wherein
a third end of the first coupler is coupled to a second end of the second coupler by using the first secondary amplification circuit, and a fourth end of the first coupler is coupled to a first end of the second coupler by using the second secondary amplification circuit;
an output end of the first primary amplification circuit is coupled to a first end of the first combiner, a third end of the second coupler is coupled to a second end of the first combiner, an output end of the second primary amplification circuit is coupled to a first end of the second combiner, and a fourth end of the second coupler is coupled to a second end of the second combiner; and
a first end of the first coupler and an input end of the first primary amplification circuit each are configured to receive a first radio frequency signal, a second end of the first coupler and an input end of the second primary amplification circuit each are configured to receive a second radio frequency signal, a frequency band of the first radio frequency signal is different from a frequency band of the second radio frequency signal, and a third end of the first combiner and a third end of the second combiner each are configured to output a combined radio frequency signal.

2. The power amplification circuit according to claim 1, wherein the first combiner and the second combiner each are a circulator; in the circulator, a radio frequency signal is transmitted in a flow direction of a first end, a second end, and a third end of the circulator, and is not transmitted in a reverse direction; the third end of the first combiner is configured to output a first combined radio frequency signal; the third end of the second combiner is configured to output a second combined radio frequency signal; the first combined radio frequency signal is a combined signal of the first radio frequency signal; and the second combined radio frequency signal is a combined signal of the second radio frequency signal.

3. The power amplification circuit according to claim 2, wherein a minimum turn-on operating power point of the first primary amplification circuit is lower than a minimum turn-on operating power point of the first secondary amplification circuit, a minimum turn-on operating power point of the second primary amplification circuit is lower than a minimum turn-on operating power point of the second secondary amplification circuit, and the minimum turn-on operating power point of the first secondary amplification circuit is lower than, equal to, or higher than a minimum turn-on operating power point of the second secondary amplification circuit.

4. The power amplification circuit according to claim 1, wherein the first combiner and the second combiner are inter-frequency power splitters, the first ends and the third ends of the first combiner and the second combiner are splitting ends of the inter-frequency power splitters, and the second ends of the first combiner and the second combiner are combining ends of the inter-frequency power splitters;
the first end of the first combiner presents band-pass for the first radio frequency signal and presents band-stop for the second radio frequency signal, the third end of the first combiner presents band-pass for the second radio frequency signal and presents band-stop for the first radio frequency signal, the second end of the first combiner presents band-pass for the first radio frequency signal and the second radio frequency signal, and the third end of the first combiner is configured to output a second combined radio frequency signal;
the first end of the second combiner presents band-pass for the second radio frequency signal and presents band-stop for the first radio frequency signal, the third end of the first combiner presents band-pass for the first radio frequency signal and presents band-stop for the second radio frequency signal, the second end of the second combiner presents band-pass for the first radio frequency signal and the second radio frequency signal, and the third end of the second combiner is configured to output a first combined radio frequency signal; and
the first combined radio frequency signal is a combined signal of the first radio frequency signal, and the second combined radio frequency signal is a combined signal of the second radio frequency signal.

5. The power amplification circuit according to claim 4, wherein a minimum turn-on operating power point of the first primary amplification circuit is lower than a minimum turn-on operating power point of the first secondary amplification circuit, a minimum turn-on operating power point of the second primary amplification circuit is lower than a minimum turn-on operating power point of the second secondary amplification circuit, and the minimum turn-on operating power point of the first secondary amplification circuit is lower than, equal to, or higher than a minimum turn-on operating power point of the second secondary amplification circuit.

6. The power amplification circuit according to any one of claims 1 to 5, wherein at least one of the first primary amplification circuit, the second primary amplification circuit, the first secondary amplification circuit, and the second secondary amplification circuit is a power combining circuit, and the power combining circuit comprises a plurality of amplification branch circuits.

7. The power amplification circuit according to claim 6, wherein the power combining circuit comprises at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation amplification circuit.

8. The power amplification circuit according to any one of claims 1 to 7, wherein the power amplification circuit further comprises a splitting circuit, and the splitting circuit is configured to: input the first radio frequency signal and the second radio frequency signal, separately output the first radio frequency signal to the input end of the first primary amplification circuit and the first end of the first coupler, and separately output the second radio frequency signal to the input end of the second primary amplification circuit and the second end of the first coupler.

9. The power amplification circuit according to claim 8, wherein the splitting circuit comprises a first power splitter and a second power splitter;
a combining end of the first power splitter is configured to receive the first radio frequency signal, and a first splitting end and a second splitting end of the first power splitter are separately configured to output one first radio frequency signal; and
a combining end of the second power splitter is configured to receive the second radio frequency signal, and a first splitting end and a second splitting end of the second power splitter are separately configured to output one second radio frequency signal.

10. The power amplification circuit according to claim 8, wherein the splitting circuit comprises a first inter-frequency power splitter and a second inter-frequency power splitter;
a combining end of the first inter-frequency power splitter is configured to receive the first radio frequency signal and the second radio frequency signal, a first splitting end of the first inter-frequency power splitter outputs one first radio frequency signal, and a second splitting end of the first inter-frequency power splitter is configured to output one second radio frequency signal; and
a combining end of the second inter-frequency power splitter is configured to receive the first radio frequency signal and the second radio frequency signal, a first splitting end of the second inter-frequency power splitter outputs one first radio frequency signal, and a second splitting end of the second inter-frequency power splitter is configured to output one second radio frequency signal.

11. The power amplification circuit according to claim 8, wherein the splitting circuit comprises a third inter-frequency power splitter, a third power splitter, and a fourth power splitter, and a first splitting end and a second splitting end of the third inter-frequency power splitter are respectively coupled to a combining end of the third power splitter and a combining end of the fourth power splitter, wherein
a combining end of the third inter-frequency power splitter is configured to receive the first radio frequency signal and the second radio frequency signal, the first splitting end of the third inter-frequency power splitter is configured to output the first radio frequency signal, and the second splitting end of the third inter-frequency power splitter is configured to output the second radio frequency signal;
a first splitting end and a second splitting end of the third power splitter are separately configured to output one first radio frequency signal; and
a first splitting end and a second splitting end of the fourth power splitter are separately configured to output one second radio frequency signal.

12. The power amplification circuit according to any one of claims 1 to 11, wherein the first radio frequency signal and the second radio frequency signal comprise a radio frequency signal of one or more sub-bands.

13. A radio frequency generation device, comprising a radio frequency generation circuit and the power amplification circuit according to any one of claims 1 to 12, wherein the radio frequency generation circuit is configured to output a radio frequency signal to the power amplification circuit, and the power amplification circuit is configured to perform power-combining amplification based on the radio frequency signal.

14. A communication system, comprising a baseband processing device and the radio frequency generation device according to claim 13, wherein the baseband processing device is configured to output a baseband signal to the radio frequency generation device, and the radio frequency generation device is configured to: obtain a radio frequency signal based on the baseband signal, and perform power-combining amplification on the radio frequency signal.
